# EUROPEAN PATENT SPECIFICATION

(11) **EP 3 913 681 B1**
(45) Date of publication and mention of the grant of the patent: **18.09.2024**
(21) Application number: 21174210.1
(22) Date of filing: 17.05.2021
(51) Int. Cl.: H01L 31/052, H10N 19/00, H10N 10/01, H10N 10/851, H10N 10/17, H10N 10/852

(54) **METHOD OF FABRICATION OF AN INTEGRATED THERMOELECTRIC CONVERTER, AND INTEGRATED THERMOELECTRIC CONVERTER THUS OBTAINED**
VERFAHREN ZUR HERSTELLUNG EINES INTEGRIERTEN THERMOELEKTRISCHEN WANDLERS UND SO ERHALTENER INTEGRIERTER THERMOELEKTRISCHER WANDLER
PROCÉDÉ DE FABRICATION D'UN CONVERTISSEUR THERMOÉLECTRIQUE INTÉGRÉ ET CONVERTISSEUR THERMOÉLECTRIQUE INTÉGRÉ AINSI OBTENU

(30) Priority: 18.05.2020 IT 202000011335; 14.05.2021 US 202117321252
(43) Date of publication of application: 24.11.2021
(73) Proprietor: STMicroelectronics S.r.l., 20864 Agrate Brianza (MB) (IT)
(72) Inventor: FERRARI, Paolo, 21013 Gallarate (VA) (IT); VILLA, Flavio Francesco, 20159 Milano (IT); ZULLINO, Lucia, 20144 Milano (IT); NOMELLINI, Andrea, 20131 Milano (IT); SEGHIZZI, Luca, 20125 Milano (IT); ZANOTTI, Luca, 20864 Agrate Brianza (MB) (IT); SCOLARI, Martina, 20131 Milano (IT); MURARI, Bruno, 20052 Monza (IT)
(74) Representative: Studio Torta S.p.A.

(56) References cited:
- CN-A- 103 199 188
- CN-A- 106 486 593
- DE-A1- 102006 015 492
- US-A1- 2006 102 223
- US-A1- 2011 048 488
- US-A1- 2011 083 711
- US-A1- 2011 174 362
- STRASSER M ET AL: "Miniaturized thermoelectric generators based on poly-Si and poly-SiGe surface micromachining", SENSORS AND ACTUATORS A: PHYSICAL, ELSEVIER BV, NL, vol. 97-98, 1 April 2002 (2002-04-01), pages 535 - 542, XP004361648, ISSN: 0924-4247, DOI: 10.1016/S0924-4247(01)00815-9

## Description

The present invention generally relates to the field of solid-state technology, particularly semiconductor technology and devices, and more particularly to a solid-state, integrated thermoelectric converter, like a ThermoElectric Generator (aka "TEG"), and to a fabrication method thereof.

### Description of the Related Art

Direct conversion of thermal energy into electric energy (and vice-versa) by Seebeck effect is a promising approach for harvesting energy from heat sources, particularly when reduced temperature gradients are involved and that, as such, would otherwise not be exploited (such as waste heat of industrial plants, residual heat of car engines, low temperature thermal sources).

Thermoelectric generators are low enthalpy waste heat exploitation devices that are used, for example, in battery-free radiator valve actuators or in torches (in this latter case, exploiting the difference in temperature between the human body temperature and the ambient temperature).

Thermoelectric generators make use of thermoelectric materials that are capable of generating power directly from the heat by converting temperature differences into electric voltage.

A good thermoelectric material should have both high electrical conductivity (σ) and low thermal conductivity (κ). Having low thermal conductivity ensures that when one side of the material is made hot, the other material side stays cold, which helps to generate a significant voltage even with a low temperature gradient.

Tellurium-based thermoelectric generators make use, as thermoelectric material, of materials based on Tellurium.

Tellurium compounds, such as Bismuth Telluride (Bi₂Te₃), exhibit good Seebeck coefficients (the Seebeck coefficient, also known as thermopower, thermoelectric power, thermoelectric sensitivity, of a material is a measure of the magnitude of an induced thermoelectric voltage in response to a temperature difference across that material, as induced by the Seebeck effect), high electrical conductivity and low thermal conductivity (just as an example, the thermal conductivity of Bismuth Telluride is 2W/mK). These properties make Bismuth Telluride suitable to be used to form the "thermoelectrically active elements" of a thermoelectric generator (by "thermoelectrically active elements" or "active elements" it is meant the thermoelectric elements in thermoelectric material that are capable of converting a thermal drop or temperature gradient across them into an electric potential by Seebeck effect).

A Tellurium-based thermoelectric generator includes a plurality of interconnected n-doped Bismuth Telluride active elements and p-doped Bismuth Telluride active elements (the active elements being also referred to as "legs") between a pair of opposite ceramic substrates provided with metal (Cu or Au) contact regions and conductive lines, that interconnect the plurality of n-doped and p-doped Bismuth Telluride active elements. The n-doped Bismuth Telluride active elements are formed as discrete elements, typically by means of a process that involves forming ingots starting from powder material and then dicing the ingots to form pellets that will then form the Seebeck legs when the pellets are put (in a manual or semi-automatic assembling stage) between the two ceramic substrate.

The existing Tellurium-based thermoelectric generators are therefore discrete components. Bismuth Telluride is not suitable to be used as a material in standard Integrated Circuit (IC) manufacturing processes, which instead are based on Silicon.

Moreover, Tellurium-based thermoelectric generators typically exhibit a relatively good efficiency only in a limited temperature range (usually, of the order of 100 K around room temperature) and thermoelectric properties that rapidly degrade as temperature increases. This reduces the fields of application of the Tellurium-based thermoelectric generators.

Additionally, Tellurium is a relatively rare element, which inherently limits a widespread use thereof.

Furthermore, an extensive use of Tellurium compounds, such as Bismuth Telluride, could pose environmental problems, in particular in term of end-of-life device disposal.

In silicon-based thermoelectric generators, materials based on Silicon (n-doped and p-doped, so as to exhibit different Seebeck coefficients) are used as thermoelectric material to form the active elements.

Silicon-based thermoelectric generators manufactured with Silicon-compatible technologies can be classified in two families: in devices of a first family the heat flow is parallel to the substrate whereas in the other family the heat flow is orthogonal to the substrate ("out-of-plane" heat flux). The architectures of these integrated thermoelectric generators generally comprise a number of elementary cells having n-p doped legs, arranged in such a way that the elementary cells are thermally in parallel and electrically in series. Typically, integrated thermoelectric generators in which heat flows parallel to the substrate may have conductive legs of thermoelectrically active materials deposited over a very high thermal resistance material or a membrane, suspended several hundreds of micrometers above the substrate, or the legs of active materials themselves are free-standing (membrane-less).

Out-of-plane heat flux thermoelectric generators minimizes thermal losses, simplify thermal coupling at system level, enhancing overall performance, and are amenable to miniaturization and integration in microelectronic and optoelectronic devices, among other applications.

The paper by M. Tomita et al., "10µW/cm2-Class High Power Density Planar Si-Nanowire Thermoelectric Energy Harvester Compatible with CMOS-VLSI Technology", 38th IEEE Symposium on VLSI Technology, VLSI Technology 2018, Honolulu, United States, 18-22/6/18 criticizes planar Si-based thermoelectric generators employing long Si-nanowires about 10-100 µm as active elements, which are suspended on a cavity to cutoff the bypass of the heat current to secure the temperature difference across the Si-nanowires. The authors of the paper propose a design concept of planar and short thermoelectric generator without cavity structure, which uses a steep temperature gradient formed in the vicinity of the main heat current.

WO 2018/078515 discloses an integrated thermoelectric generator of out-of-plane heat flux configuration. The generator further includes a top capping layer deposited onto a free surface, oriented in an opposite direction in respect to said void spaces, of said planar electrically non-conductive cover layer so as to occlude the through holes of the non-conductive cover layer.

The article "Miniaturized thermoelectric generators based on poly-Si and poly-SiGe surface micromachining" by M. Strasser et al, SENSORS AND ACTUATORS A/PHYSICAL, ELSEVIER BY, NL, vol. 97-98, 1 April 2002, pages 535-542, XP004361648, ISSN: 0924-4247, DOI: 10.1016/S924-4247 (01) 00815-9 discloses generators using BiCMOS technology by forming thermocouples of opposite conductivity silicon in a thick poly-Si or poly Si-Ge layer that is patterned to form the n- and p- legs. LOCOS oxide is used to thermally isolate the cold and the hot side.

DE 10 2006 015492 discloses a thermoelectric generator comprising columnar elements of polysilicon and opposite conductivities extending from a substrate that are grown in separate steps.

US 2006/102223, CN 106486593 and CN 103199188 disclose other thermoelectric generators of SiGe, or semiconductor alloys or metals.

The Applicant has realized that the Silicon-based thermoelectric generators proposed in the art exhibit drawbacks.

Silicon has a large electrical conductivity and a good Seebeck coefficient, but, as a thermoelectric material, it has the disadvantage of featuring a high thermal conductivity (148 W/mK) compared to Bismuth Telluride (which has a thermal conductivity of 2 W/mK). Furthermore, Silicon-based thermoelectric generators having a cavity have a low mechanical stability because of the presence of the cavity. Other drawbacks of known Silicon-based thermoelectric generators are: difficulty to industrialize; low power (~ 100 µW /cm²); and high semiconductor area consumption.

The Applicant has tackled, among others, the problem of devising a novel thermoelectric converter overcoming, among others, the drawbacks that affect known thermoelectric generators.

According to the invention, a method of fabricating a thermoelectric converter and an integrated thermoelectric converter are provided, as defined in the attached claims.

The features and advantages of the present disclosure will be made apparent by the following description of example embodiments thereof, provided merely as non-limitative examples.

For its better intelligibility, the following description should be read making reference to the attached drawings, wherein:
Figs. 1A - 1G show some steps of a fabrication method of a thermoelectric converter according to the present disclosure;
Figs. 2A - 2P show some steps of a fabrication method of a thermoelectric converter according to the present disclosure;
Figs. 3A - 3L show some steps of a fabrication method of a thermoelectric converter according to still an example embodiment of the present disclosure;
Figs. 4A - 4E show some steps of the fabrication method following the steps of Figs. 2A - 2P or Figs. 3A - 3L, in an example embodiment of the present disclosure (same or similar process steps can also follow the steps of Figs. 1A- 1G);
Fig. 4F shows example steps for the formation of contact pads;
Fig. 5 shows, in top plan view, a layout of a thermoelectric converter obtained by a method according to an example embodiment of the present disclosure, including steps shown in Figs. 1A - 1G and steps similar to those of Figs. 4A - 4E;
Fig. 6 show, in top plan view, a layout of a thermoelectric converter obtained by a method according to the embodiment of the present disclosure, including steps shown in Figs. 2A - 2P or Figs. 3A - 3L and Figs. 4A - 4E;
Fig. 7 shows a simplified block diagram of an electronic system comprising a thermoelectric converter according to an embodiment of the present disclosure;
Figs. 8 shows a cross-section, taken along section line VIII-VIII of Figs. 9A and 9B, of a solar energy recovery device using the thermoelectric converter of Figure 4F, after bonding the thermoelectric wafer and a solar cell wafer;
Fig. 9A is a top plan view of the thermoelectric wafer of Figure 8, before bonding;
Fig. 9B is a bottom plan view of the solar cell wafer of Figure 8, before bonding;
Figure 10 is a cross-section of the solar energy recovery device of Fig. 8 in a further manufacturing step;
Figure 11 is a cross-section taken along section line XI-XI of Figs. 12A and 12B of the solar energy recovery device of Fig. 10 in a further manufacturing step;
Fig. 12A is a top plan view of the thermoelectric wafer of Figure 11;
Fig. 12B is a bottom plan view of the solar cell wafer of Figure 11;
Figure 13 is a scheme depicting a possible connection of the solar energy recovery device of Fig. 11;
Figures 14 and 15 show cross-sections of a solar energy recovery device not according to the present invention in different manufacturing steps;
Figure 16 is a cross-section of a different solar energy recovery device not according to the present invention;
Figure 17 is a schematic representation of a system disclosed therein; and
Figure 18 is a cross-section of an example of a solar cell wafer that may be used in the solar energy recovery device according to this disclosure.

It is pointed out that the drawings in the figures are not necessarily drawn to scale.

### DETAILED DESCRIPTION OF EXAMPLE EMBODIMENTS OF THE PRESENT INVENTION

In the following, reference will be made to the drawings, which show some steps of fabrication methods of a thermoelectric converter according to example embodiments of the present disclosure. In the drawings, like and/or corresponding elements are denoted by like reference numerals.

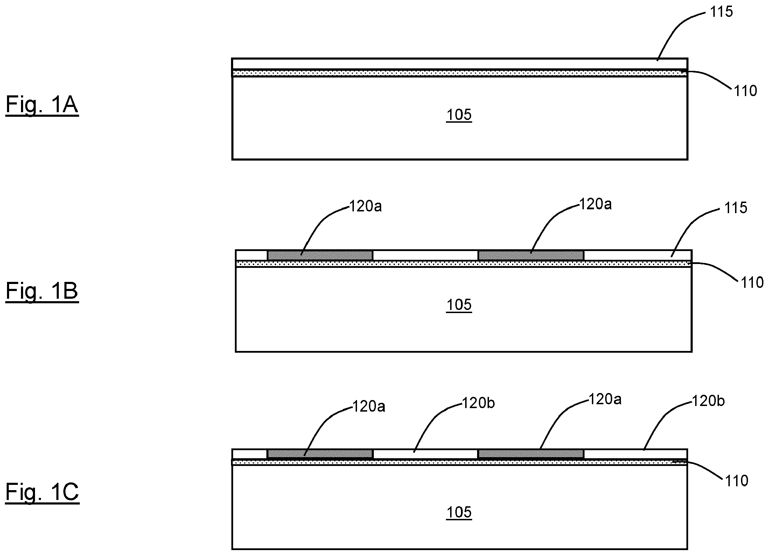

Reference is firstly made to Figs. 1A - 1G, which show some steps of a fabrication method.

Starting from a Silicon substrate (first Silicon wafer) 105, a surface of the Silicon substrate 105 is oxidized (e.g., by means of thermal oxidation) to form a layer of oxide 110, *e.g.,* Silicon dioxide (SiO₂). Then, a layer 115 of polycrystalline SiGe is formed over the layer of oxide 110. The resulting structure is schematically depicted in Fig. 1A.

The layer 115 of polycrystalline SiGe is for example a layer of polycrystalline Si_{0.7}Ge_{0.3}. The layer 115 of polycrystalline SiGe can for example be formed by means of deposition, for example, but not limitatively, chemical deposition, for example, Chemical Vapor Deposition (CVD); among the several different CVD techniques, Low Pressure CVD (LPCVD) can for example be exploited. Deposition takes place from silane (SiH₄) and germane (GeH₄). Alternatively, the layer 115 of SiGe polysilicon can be formed by means of epitaxial growth in an epitaxial reactor. Both techniques produce a conformal layer 115 of polycrystalline SiGe.

The layer 115 of polycrystalline SiGe can for example have a thickness of some microns, *e*.*g*., about 1 µm.

Then, as depicted in Figs. 1B and 1C, alternated n+ doped regions 120a and p+ doped regions 120b of n+ doped and, respectively, p+ doped polycrystalline SiGe are formed in the layer 115 of polycrystalline SiGe. The dopants (donor dopants for the n+ doped regions 120a and acceptor dopants for the p+ doped regions 120b) can be selectively introduced into the layer 115 of polycrystalline SiGe by ion implantation. For example, suitable donor dopants can be Phosphorus or Arsenic, a suitable acceptor dopant can be Boron. The n+ doped regions 120a and p+ doped regions 120b can for example take shape of substantially parallel strips formed in the layer 115 of polycrystalline SiGe (where "parallel" is meant to intend along a direction orthogonal to the plane of the drawing sheet of Figs. 1B and 1C), alternated and for example (but not limitatively) contiguous to each other (in a direction from the left to the right of the drawing sheet).

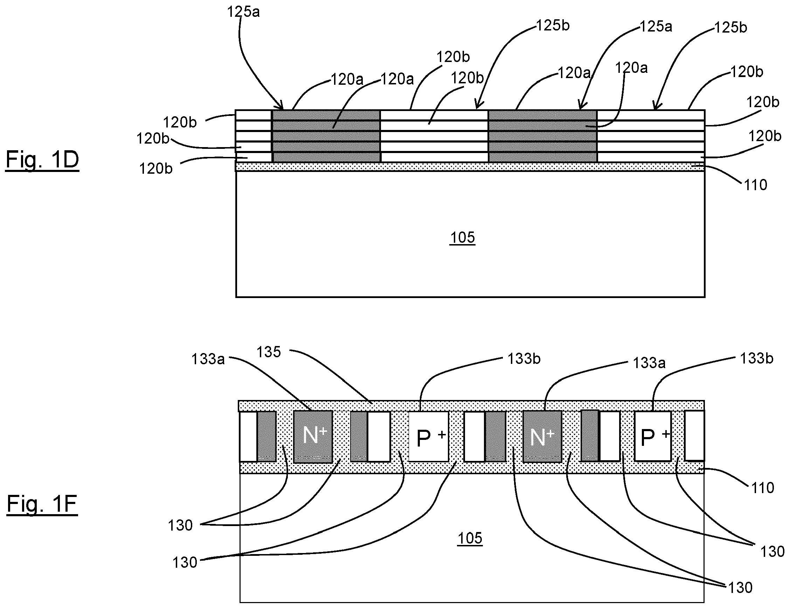

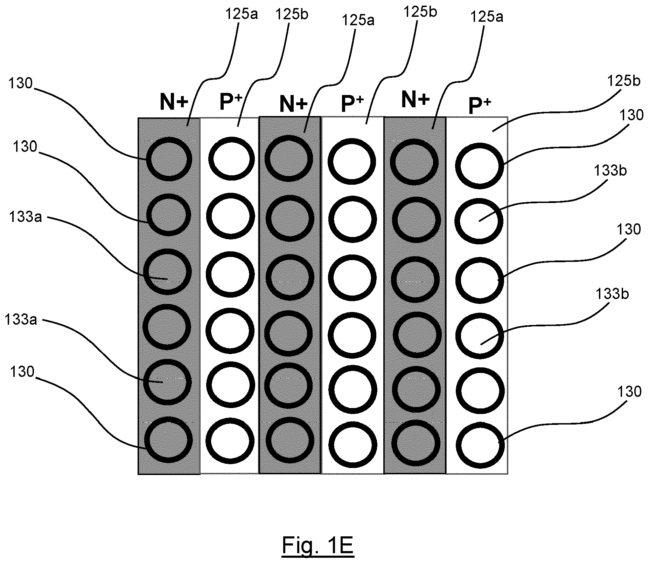

The steps of forming a layer of polycrystalline SiGe and forming, in the layer of polycrystalline SiGe, n+ and p+ doped regions are repeated twice or more times. As depicted in Fig. 1D, every new layer of polycrystalline SiGe is formed (for example by the same technique as the first layer 115 of polycrystalline SiGe) on the preceding layer of polycrystalline SiGe, and in each newly formed layer of polycrystalline SiGe n+ and p+ doped regions 120a and 120b are formed (for example, by ion implantation) in (vertical, *e.g.,* in a direction from the bottom to the top of the drawing sheet of Fig. 1D) alignment with the previously formed n+ and p+ doped regions 120a and 120b formed in the preceding layer(s) of polycrystalline SiGe. In this way, stacks 125a of n+ doped regions and stacks 125b of p+ doped regions are obtained, from which the thermoelectric elements of the thermoelectric converter will be formed. In this way, the stacks 125a of n+ doped regions and the stacks 125b of p+ doped regions take the form of substantially parallel strips formed in the stack of layers of polycrystalline SiGe (where, again, "parallel" is meant to intend along the direction orthogonal to the plane of the drawing sheet of Fig. 1D), alternated and for example (but not limitatively) contiguous to each other (in the direction from the left to the right of the drawing sheets), as visible, *e*.*g*., in Fig. 1E.

The number of times that the steps of forming a layer of polycrystalline SiGe and forming, in the layer of polycrystalline SiGe, n+ and p+ doped regions are repeated depends on the thickness of each one of the layers of polycrystalline SiGe (the stacked layers of polycrystalline SiGe may have all the same thickness or different thicknesses from each other), and on the desired overall thickness of the stack of layers of polycrystalline SiGe. The overall thickness of the stack of layers of polycrystalline SiGe should be such as to ensure a sufficient thermal difference between the bottom and the top of the stacks 125a of n+ doped regions and stacks 125b of p+ doped regions, even for relatively low temperature gradients. For example, the overall thickness of the stack of layers of polycrystalline SiGe can be of some tens of microns, particularly from about 10 µm to about 30 µm (thus, for an example thickness of the generic layer of polycrystalline SiGe of about 1 µm, the steps of forming a layer of polycrystalline SiGe and forming, in the layer of polycrystalline SiGe, n+ and p+ doped regions are repeated some tens of times).

Trenches 130 are then formed in the stacks 125a of n+ doped regions and in the stacks 125b of p+ doped regions. The trenches 130 are for example formed as cylindrical shells. The trenches 130 extend down to the layer of oxide 110. Multiple trenches 130 are formed along each stack 125a and 125b, that are strip-like shaped, as shown in Fig. 1E. Each trench 130 delimits a respective (e.g., cylindrical) portion 133a of a respective stack 125a of n+ doped regions or a respective (e.g., cylindrical) portion 133b of a respective stack 125b of p+ doped regions, which portions 133a and 133b remain separated from the rest of the respective stack 125a of n+ doped regions and stack 125b of p+ doped regions. The (e.g., cylindrical) portions 133a and 133b of the stacks 125a of n+ doped regions and of the stacks 125b of p+ doped regions will form the thermoelectrically active elements (*e*.*g*., the "legs") of the thermoelectric converter.

By means of an oxidation process the trenches 130 are filled with oxide and the top surface of the structure (e.g., the surface opposite to the Silicon substrate 105) is covered by an oxide layer 135. The oxide can for example be SiO₂. In particular, the oxidation process can involve a thermal oxidation process for coating the lateral walls of the trenches 130 with oxide, followed by a deposition of a thick oxide layer using TEOS (TetraEthyl OrthoSilicate) filling the trenches and covering the surface of the structure with the oxide layer 135. The resulting structure is shown in Fig. 1F. In this way, the (*e.g.,* cylindrical) portions of the stacks 125a of n+ doped regions and of the stacks 125b of p+ doped regions which are delimited by the trenches 130 remain insulated from the remaining of the respective stacks 125a of n+ doped regions and stacks 125b of p+ doped regions. As mentioned, the (*e.g.,* cylindrical) portions of the stacks 125a of n+ doped regions and of the stacks 125b of p+ doped regions which are delimited by the trenches 130 will form the thermoelectric elements (*e.g.,* the "legs") 133a (n doped, *e.g.,* having a first Seebeck coefficient, particularly of a first sign, *e.g.,* positive) and 133b (p doped, *e.g.,* having a second, different Seebeck coefficient, particularly of an opposite sign, *e*.*g*., negative) of the thermoelectric converter.

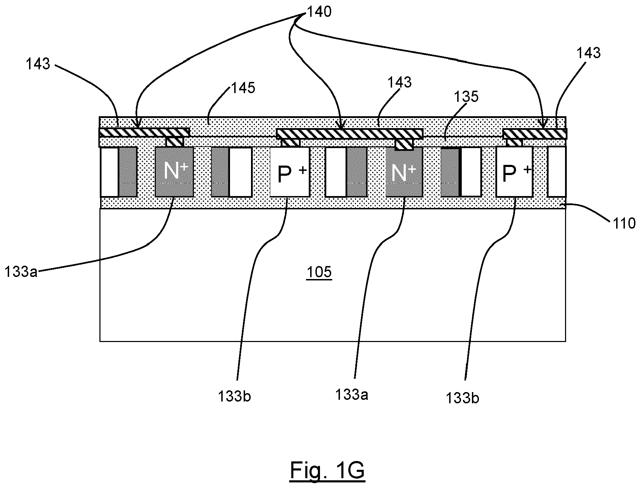

As visible in Fig. 1G, contact openings are formed in the oxide layer 135 in correspondence of the n+ doped thermoelectric elements 133a and of the p+ doped thermoelectric elements 133b delimited by the trenches 130, and a conductive layer 140, *e.g.,* of a metal, is formed on the oxide layer 135 and then patterned to define conductive lines 143 interconnecting the n+ doped thermoelectric elements 133a and the p+ doped thermoelectric elements 133b. The surface of the structure is then covered by a layer 145 of oxide, *e.g.,* SiO₂.

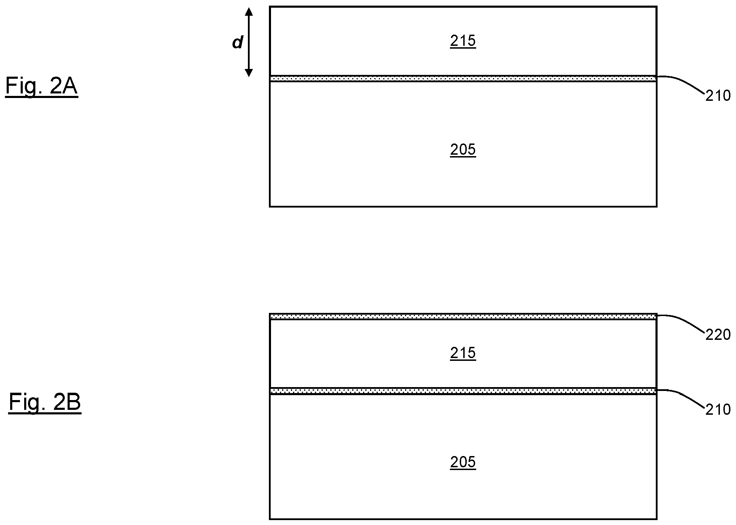

Reference is now made to Figs. 2A - 2P, which show some steps of a method

Starting from a Silicon substrate (first Silicon wafer) 205, a surface of the Silicon substrate 205 is oxidized to form a layer of oxide 210, *e.g.,* Silicon dioxide (SiO₂).

Then, a (relatively thick) layer 215 of polycrystalline Silicon ("epi-poly") is formed over the layer of oxide 210. The layer 215 of polycrystalline Silicon is for example formed by means of epitaxial growth in an epitaxial reactor.

The resulting structure is depicted in Fig. 2A.

The thickness J of the layer 215 of polycrystalline Silicon should be such as to ensure a sufficient thermal difference between the bottom and the top of the thermoelectric elements that will be formed therewithin (as described in the following), even for relatively low ambient temperature gradients. For example, the thickness of the layer 215 can be of some tens of microns, particularly from about 10 µm to about 30 µm.

A surface of the layer 215 of polycrystalline Silicon is then oxidized to form a layer 220 of oxide, for example a layer of Silicon dioxide (SiO₂). The resulting structure is shown in Fig. 2B.

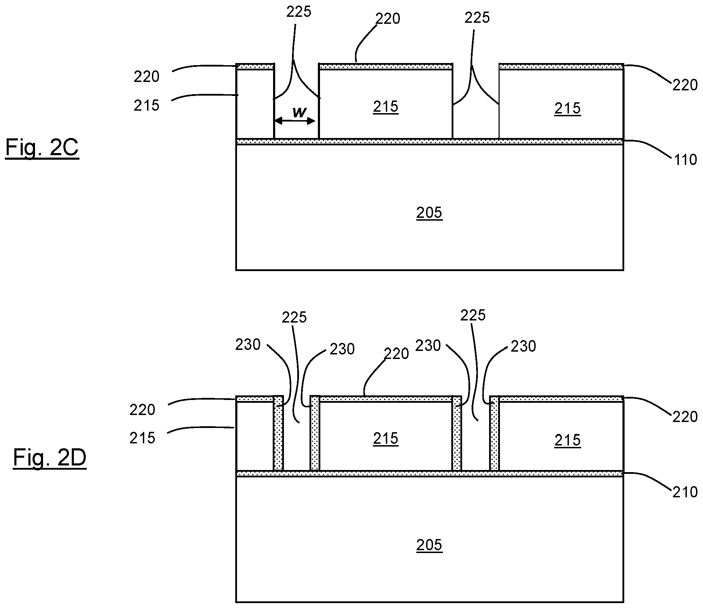

As shown in Fig. 2C, trenches 225 are then formed in the layer 215 of polycrystalline Silicon. The trenches 225 extend down to the layer of oxide 210 that covers the surface of the Silicon substrate 205. The trenches 225 may for example be cylindrical. The trenches 225 may for example have a width w of about 3 µm.

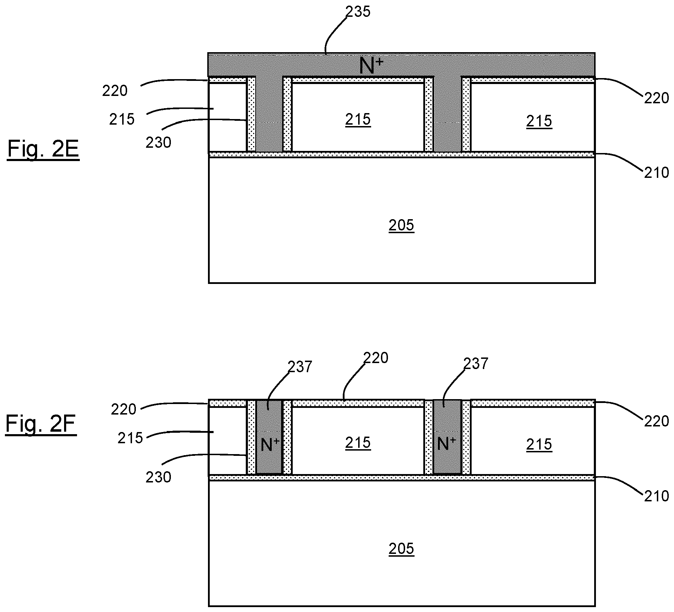

The walls of the trenches 225 are then covered by a layer of oxide 230, *e.g.,* a layer of Silicon dioxide (SiO₂), as depicted in Fig. 2D, *e.g.,* by means of thermal oxidation. In this way, cylindrical shells of oxide 230 are created inside the trenches 225.

A layer 235 of n+ doped polycrystalline SiGe is formed over the surface of the structure (*e.g.,* the surface opposite to the Silicon substrate 205). The layer 235 of n+ doped polycrystalline SiGe is for example a layer of n+ doped polycrystalline Si_{0.7}Ge_{0.3} polysilicon. The layer 235 of n+ doped polycrystalline SiGe can for example be formed by means of deposition, particularly chemical deposition, even more particularly Chemical Vapor Deposition (CVD); among the several different CVD techniques, Low Pressure CVD (LPCVD) can be exploited. Deposition takes place from silane (SiH₄) and germane (GeH₄). The n+ doped polycrystalline SiGe is conformal. During the deposition process, n+ doped polycrystalline SiGe fills the trenches 225 (with walls covered by the oxide 230). The resulting structure is shown in Fig. 2E.

By means of a Chemical-Mechanical Polishing ("CMP") step, the layer 235 of n+ doped polycrystalline SiGe is removed from over the surface of the layer 220 of oxide, leaving only (*e.g.,* cylindrical) portions 237 of the n+ doped polycrystalline SiGe within the trenches 225 (with walls covered by the oxide 230), as depicted in Fig. 2F.

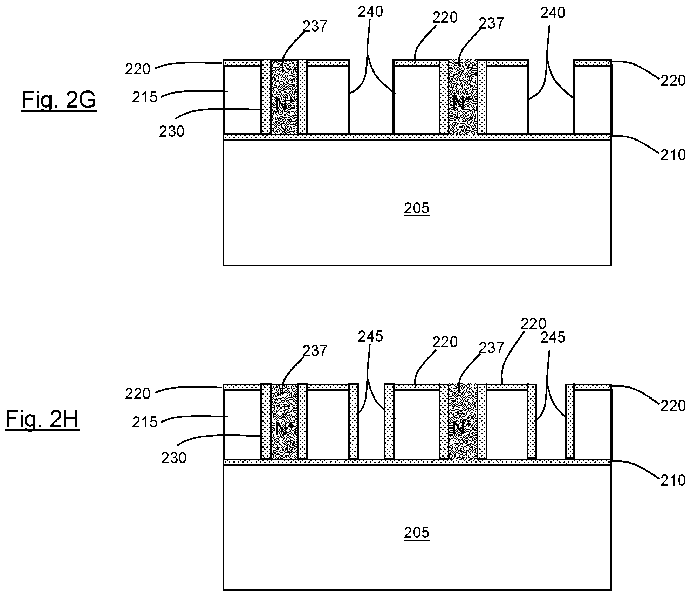

Further trenches 240 are then formed in the layer 215. Like the trenches 225, the further trenches 240 extend down to the layer of oxide 210 covering the surface of the Silicon substrate 205. The further trenches 240 may for example be cylindrical. Like the trenches 225, the trenches 240 may for example have a width of about 3 µm. The further trenches 240 are formed so as to obtain a structure, shown in Fig. 2G, in which the further trenches 240 are alternated with the trenches 225.

The walls of the further trenches 240 are then covered by a layer of oxide 245, *e.g.,* a layer of Silicon dioxide (SiO₂), for example by means of a thermal oxidation process, as depicted in Fig. 2H. In this way, cylindrical shells of oxide 245 are created inside the trenches 240.

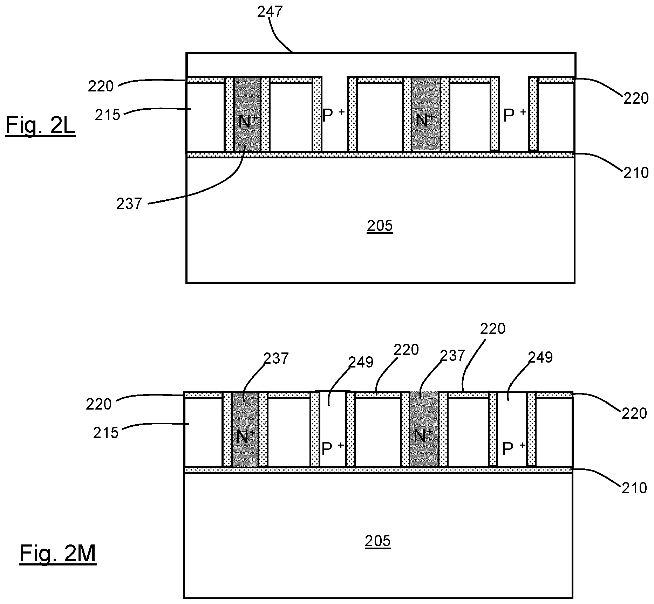

A layer 247 of p+ doped polycrystalline SiGe is formed over the surface of the structure. The layer 247 of p+ doped polycrystalline SiGe is for example a layer of p+ doped polycrystalline Si_{0.7}Ge_{0.3}. The layer 247 of p+ doped polycrystalline SiGe can for example be formed by means of deposition, particularly chemical deposition, even more particularly Chemical Vapor Deposition (CVD); among the several different CVD techniques, Low Pressure CVD (LPCVD) can be exploited. Deposition takes place from silane (SiH₄) and germane (GeH₄). The p+ doped polycrystalline SiGe is conformal. During the deposition process, p+ doped polycrystalline SiGe fills the further trenches 240 (with walls covered by the oxide 245). The resulting structure is shown in Fig. 2L.

By means of a Chemical-Mechanical Polishing ("CMP") step, the layer 247 of p+ doped polycrystalline SiGe is removed from over the surface of the layer 220 of oxide, leaving only (*e.g.,* cylindrical) portions 249 of the p+ doped polycrystalline SiGe within the further trenches 240 (with walls covered by the oxide 245), as depicted in Fig. 2M.

In this way, the (*e.g.,* cylindrical) portions 237 of n+ doped polycrystalline SiGe and the (*e.g.,* cylindrical) portions 249 of p+ doped polycrystalline SiGe which are delimited by the trenches 225 and 245 (with walls covered by the oxide 230 and 245) remain insulated from the surrounding layer 215 of polycrystalline Silicon. These (*e.g.,* cylindrical) portions 237 of n+ doped polycrystalline SiGe and portions 249 of p+ doped polycrystalline SiGe will form the thermoelectric elements (*e.g.,* the "legs") of the thermoelectric converter.

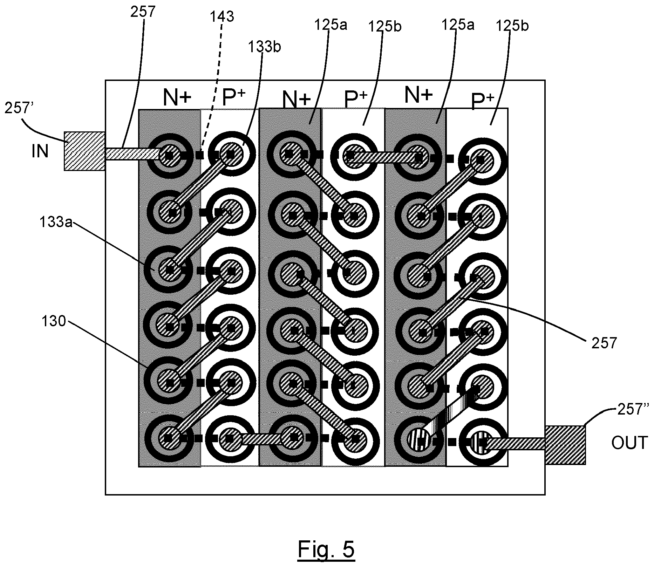

It is pointed out that each of the portions 237 of n+ doped polycrystalline SiGe and each of the portions 249 of p+ doped polycrystalline SiGe which are visible in Fig. 2M may identify a respective array of portions 237 of n+ doped polycrystalline SiGe (each one formed inside a respective trench 225 with walls covered by the oxide 230) and a respective array of portions 249 of n+ doped polycrystalline SiGe (each one formed inside a respective further trench 240 with walls covered by the oxide 245), extending along a direction orthogonal to the plane of the drawing sheet of Fig. 2M (as can be clearly understood looking at Fig. 5, to be described later on).

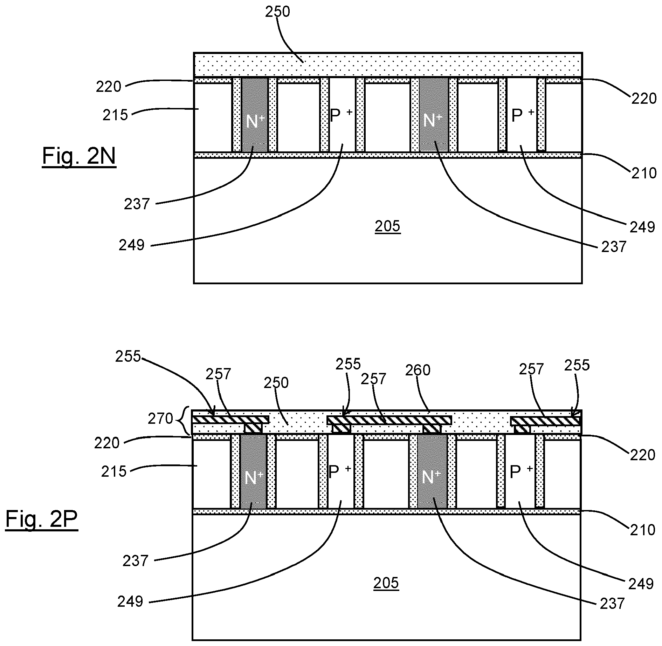

The surface of the structure (opposite to the Silicon substrate 205) is then oxidized, to form a layer of oxide 250, *e.g.,* a layer of Silicon dioxide (SiO₂), covering the whole surface of the structure, as shown in Fig. 2N.

As visible in Fig. 2P, contact openings are formed in the oxide layer 250 in correspondence of each of the portions 237 of n+ doped polycrystalline SiGe and each of the portions 249 of p+ doped polycrystalline SiGe, and a conductive layer 255, *e.g.,* of a metal, is formed on the oxide layer 250 and then patterned to define first conductive lines 257 interconnecting the thermoelectric elements 235 and 245. The surface of the structure is then covered by a further oxide layer 260, *e.g.,* SiO₂. Oxide layers 250 and 260 form, together a surface oxide layer 270 embedding the first conductive lines 257.

According to the invention, the thermoelectric elements 235 and 245, instead of being made of n+ doped and p+ doped polycrystalline SiGe, respectively, are made of n-doped and p-doped porous Silicon, respectively. Porous Silicon has an advantageously small thermal conductivity (0.15 -1.5 W/m K for porosity - 75%). The n-doped and p-doped porous Silicon thermoelectric elements 235 and 245 can be obtained by converting n⁺ and p⁺ doped polycrystalline Silicon, respectively.

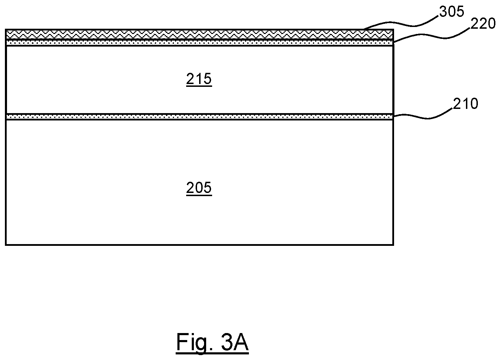

Figs. 3A - 3L depicts some steps of a process for forming the thermoelectric elements 235 and 245 made of porous Silicon.

Starting from the structure shown in Fig. 2B, a mask layer 305 (*e.g.,* a Silicon nitride layer or a thick oxide layer) is formed over the layer 220 of oxide, as depicted in Fig. 3A.

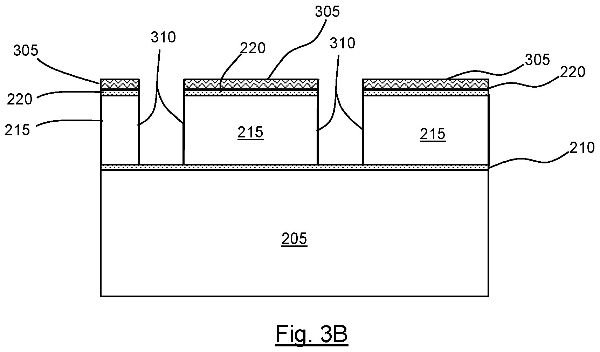

As shown in Fig. 3B, trenches 310 are then formed by selective etching, which trenches 310, starting from the surface of the mask layer 305 (that protects the structure from etching where tranches are not to be formed), extend down to the layer of oxide 210 that covers the Silicon substrate 205. The trenches 310 can be similar to the trenches 225 of the previously described embodiment (for example, cylindrical trenches having a width of about 3 µm.).

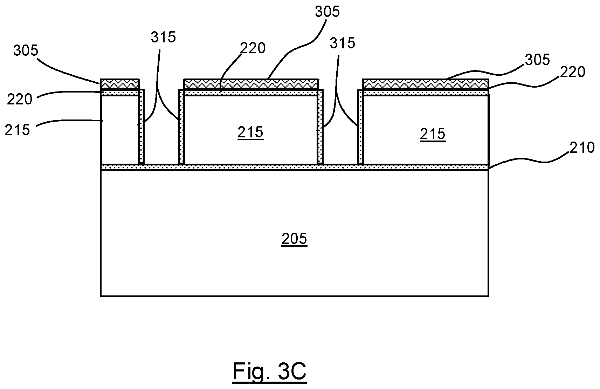

As depicted in Fig. 3C, the walls of the trenches 310 are then coated by a layer of oxide 315, for example by means of a thermal oxidation process.

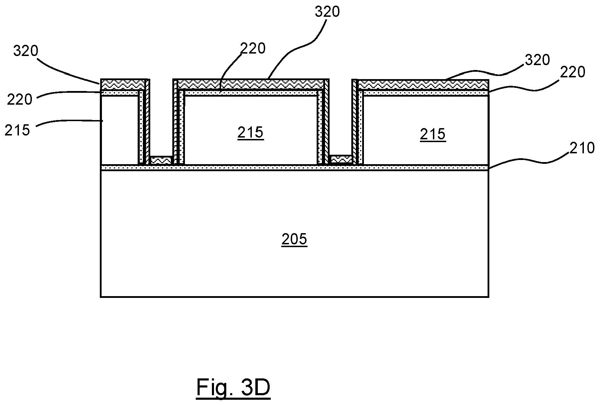

As shown in Fig. 3D, a mask layer 320 of, *e.g.,* Silicon nitride is then deposited over the whole structure. The material of the mask layer 320 penetrates into the trenches 310 and coats the walls and the bottom of the trenches 310.

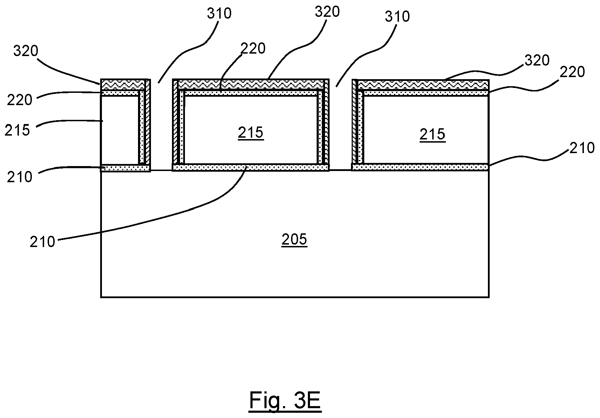

Moving to Fig. 3E, the structure is subjected to an etch process during which part of the mask layer 320 is etched away; the etch stops when the material of the mask layer 320 and the portion of the layer of oxide 210 at the bottom of the trenches 310 are removed, thereby leaving the Silicon substrate 205 exposed at the bottom of the trenches 310.

Process steps similar to those shown in Figs. 2E - 2M are then performed to fill the trenches 310 with n+ and p+ doped polycrystalline Silicon.

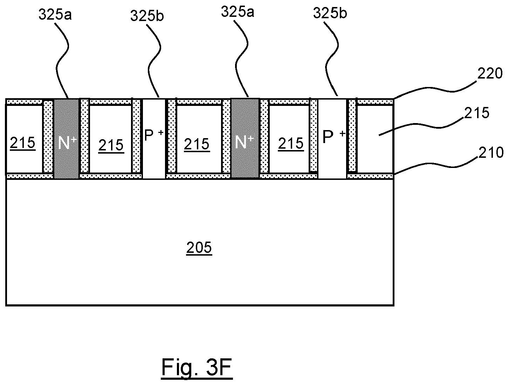

After a chemical-mechanical polishing step, the structure depicted in Fig. 3F is obtained (in this and in the following figures the layer of Silicon nitride which, after the etch of step 3E, remains at the top surface and on the lateral walls of the trenches 310, is not shown for the sake of better intelligibility). The trenches 310 are filled with (e.g., cylindrical) pillars 325a and 325b of n+ and p+ doped polycrystalline Silicon, respectively.

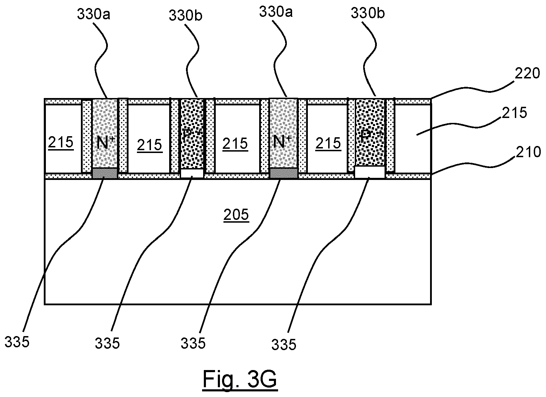

The pillars 325a and 325b of n+ and p+ doped polycrystalline Silicon are then converted into pillars of n+ and p+ doped porous Silicon. To this purpose, the structure is immersed in a tank or anodization cell, *e.g.,* made of Teflon, filled with a solution of hydrofluoric (HF) acid and provided with an anode and a cathode. The structure to be processed is connected to the anode (the cathode can for example be a mesh electrode made of Platinum). The HF acid affects the pillars 325a and 325b of n+ and p+ doped polycrystalline Silicon, transforming them into pillars of n+ and p+ doped porous Silicon. Preferably, the process is stopped before the bottom portions (base) of the pillars 325a and 325b of n+ and p+ doped polycrystalline Silicon are transformed into porous Silicon. This ensures that the integrity of the porous silicon is preserved during the subsequent phases of the fabrication process. The resulting structure is depicted in Fig. 3G, where references 330a and 330b denotes the pillars of n+ and p+ doped porous Silicon, respectively, and reference 335 denotes the bottom portions of the pillars 330a and 330b that have not undergone the transformation into porous Silicon.

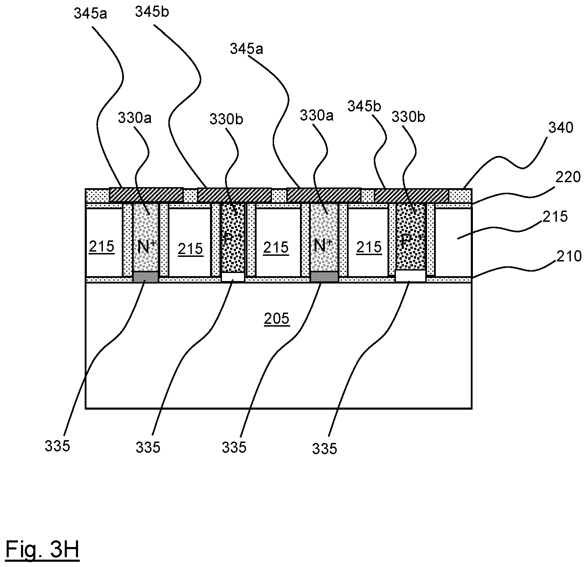

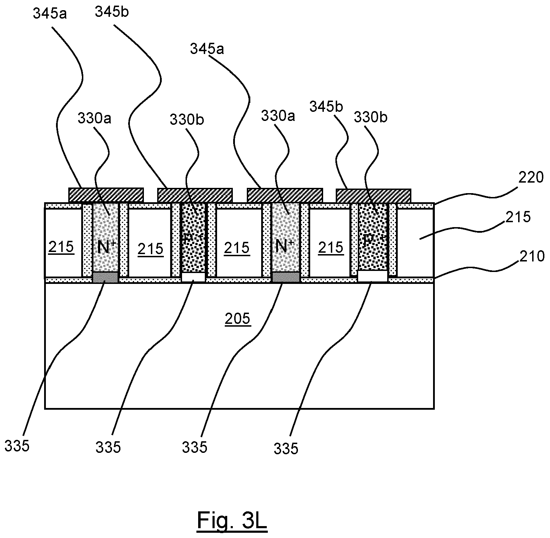

In embodiments, the process may envisage the formation (e.g., by deposition) of a layer of polycrystalline Silicon 340 over the surface of the structure. Donor and acceptor dopant ions are then selectively implanted into the polycrystalline Silicon 340 to form n+ and p+ doped polycrystalline Silicon areas 345a and 345b over the pillars of n+ and p+ doped porous Silicon 330a and 330b, respectively. The resulting structure is depicted in Fig. 3H. The remaining portions of the layer of polycrystalline Silicon 340 (other than the n+ and p+ doped polycrystalline Silicon areas 345a and 345b) are then etched away, to obtain the structure depicted in Fig. 3L. In this way, the n+ and p+ doped polycrystalline Silicon areas 345a and 345b over the pillars of n+ and p+ doped porous Silicon 330a and 330b provide enlarged contact areas to the pillars of n+ and p+ doped porous Silicon 330a and 330b that may facilitate the formation of electrical contacts to the pillars. Similar considerations may apply to the first two embodiments described in the foregoing.

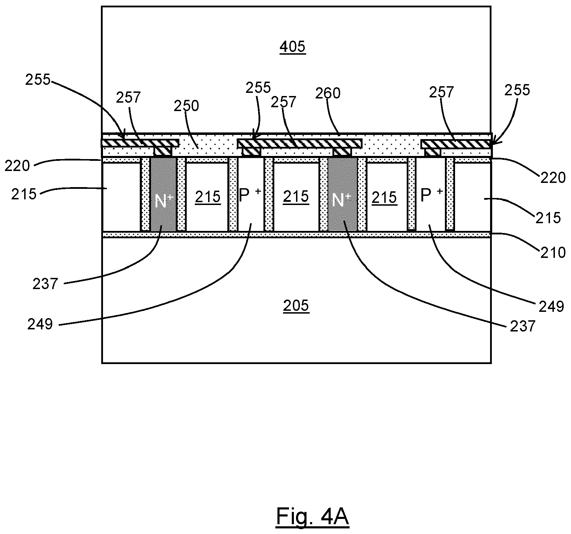

Figs. 4A to 4E show some steps of a method according to an example embodiment of the present disclosure for proceeding with the fabrication of the thermoelectric converter of any one of the previously described embodiments. Despite the steps of the fabrication method which will be described hereafter apply as well to any of the embodiments described so far, for mere reasons of simplicity they will be described and shown making reference to the second embodiment described in Figs. 2A-2P.

As shown in Fig. 4A, starting from the structure of fig. 2P, a second Silicon wafer 405 is bonded to the surface of the structure opposite to the Silicon substrate (first Silicon wafer) 205.

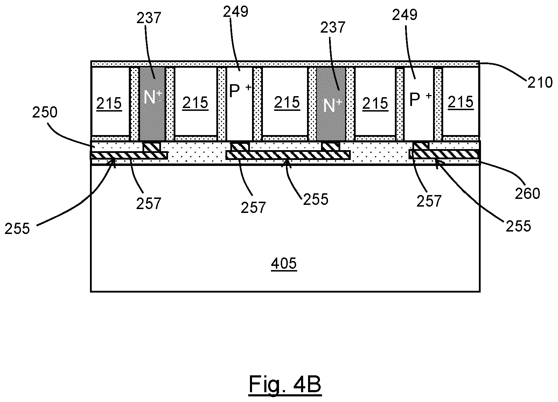

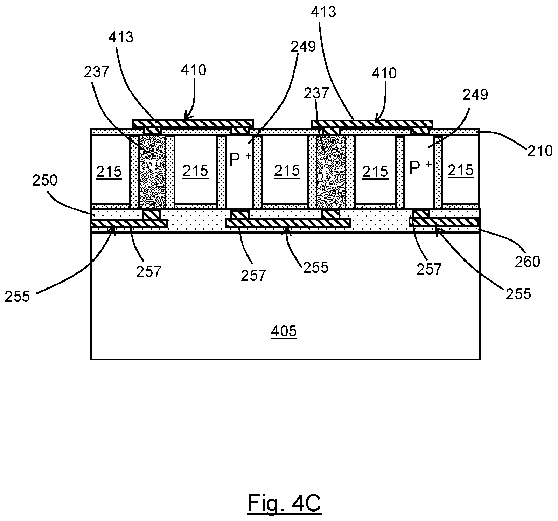

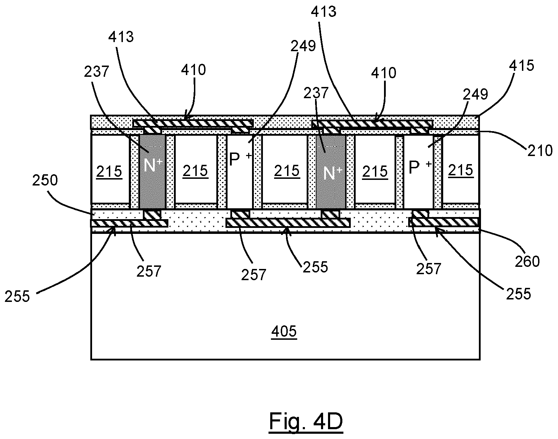

The Silicon substrate (first Silicon wafer) 205 is then removed, as shown in Fig. 4B (in which figure, as well as in the following figures Fig. 4C and Fig. 4D, the structure is depicted upside-down compared to Fig. 4A). After removal of the Silicon substrate (first Silicon wafer) 205, the layer 210 of oxide remains uncovered.

Contacts openings are formed in the layer 210 of oxide in correspondence of the thermoelectric elements 237 and 249, and a conductive layer 410, *e.g.,* of a metal, is formed on the oxide layer 210 and then patterned to define second conductive lines 413 interconnecting the thermoelectric elements 237 and 249. The resulting structure is shown in Fig. 4C.

The surface of the structure is then covered by a further layer 415 of oxide, *e.g.,* SiO₂, obtaining the structure of Fig. 4D.

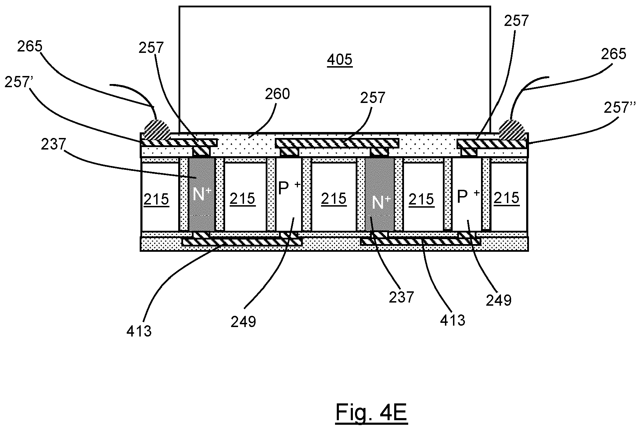

The second Silicon wafer 405 is then selectively etched to form trenches, leaving the material of the second Silicon wafer only over the thermoelectric elements 237, 249, and, where the second Silicon wafer 405 is removed, the oxide layer 260 that covered the first conductive lines 257 is etched and removed to leave portions 257', 257" of the first conductive lines 257 exposed; the exposed portions 257', 257" of the first conductive lines 257 will form contact pads of the thermoelectric converter, for soldering bonding wires 265 (similar portions of the conductive lines 143 in the structure of Fig. 1G will form the contact pads). The resulting structure is shown in Fig. 4E (oriented similarly to Figs. 2A - 2P).

The side of the structure where there is the (portion of the) second Silicon wafer 405 (left and not removed) will, in use, be for example the "hot" side of the thermoelectric converter (e.g., the side where the temperature of the environment where the thermoelectric converter is inserted is higher), while the opposite side of the structure will, in use, be for example the "cold" side of the thermoelectric converter (e.g., the side where the temperature of the environment where the thermoelectric converter is inserted is lower). Naturally, in use the role of the "hot" and "cold" sides of the thermoelectric converter can be reverted: generally, the two sides of the thermoelectric converter will in use experiment a temperature gradient. The portion(s) of the second Silicon wafer 405 left and not removed can form a structural support for the device.

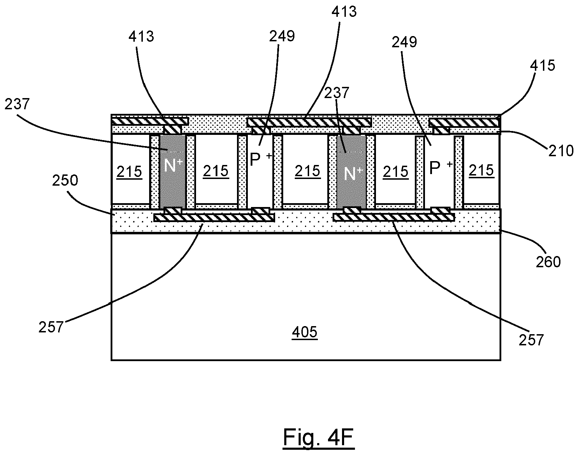

Fig. 4F shows an alternative to steps 4D and 4E for the formation of contact pads for the bonding wires 265. In this case, the contact pads can be portions of the second conductive lines 413 interconnecting the thermoelectric elements 237 and 249. To open contact areas for the contact pads, the layer 415 of oxide is selectively etched. It is not necessary to selectively etch the second Silicon wafer 405, which can be left as it is for acting as a mechanical support for the structure.

Fig. 5 shows the layout of the structure obtained by the fabrication process of Figs. 1A - 1G and subsequent steps like those shown in figs. 4A - 4E. The device comprises a plurality of first thermoelectric elements 133a (n doped, *e*.*g*., having a first Seebeck coefficient, particularly of a first sign, *e*.*g*., positive) and a plurality of second thermoelectric elements 133b (p doped, *e*.*g*., having a second, different Seebeck coefficient, particularly of an opposite sign, *e*.*g*., negative). Each first thermoelectric element and each second thermoelectric element has a first end at the "hot" side of the device and a second end at the "cold" side of the device. The first and second thermoelectric elements 133a and 133b are arranged in alternated arrays that extend parallel to each other and are contacted (at the opposite ends of the thermoelectric elements, "hot" side and "cold" side") by the conductive lines 143 (here forming first conductive lines 257) and second conductive lines 413, in "zig-zag" fashion. The first conductive lines 257 have an input contact pad 257' and an output contact pad 257".

The first and second thermoelectric elements 133a and 133b are thermally in parallel and electrically in series.

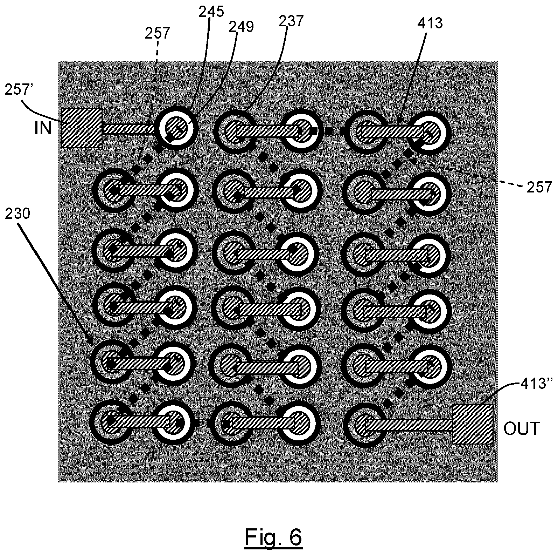

Fig. 6 shows the layout of the structure obtained by the fabrication process of Figs. 2A - 2P (or 3A - 3L) and 4A - 4D and 4F.

Therefore, the device of Fig. 6 comprises a plurality of first thermoelectric elements 237 (n doped, *e*.*g*., having a first Seebeck coefficient, particularly of a first sign, *e.g.,* positive) and a plurality of second thermoelectric elements 249 (p doped, *e.g.,* having a second, different Seebeck coefficient, particularly of an opposite sign, *e*.*g*., negative). Each first thermoelectric element 237 and each second thermoelectric element 249 has a first end at the "hot" side of the device and a second end at the "cold" side of the device. The first and second thermoelectric elements 237 and 249 are arranged in alternated rows or arrays that extend parallelly to each other and are contacted (at the opposite ends of the thermoelectric elements, "hot" side and "cold" side") by the first conductive lines 257 and the second conductive lines 413, in "zig-zag" fashion. The second conductive lines 413 have an input contact pad 413' and an output contact pad 413".

The first and second thermoelectric elements 237 and 249 are thermally in parallel and electrically in series.

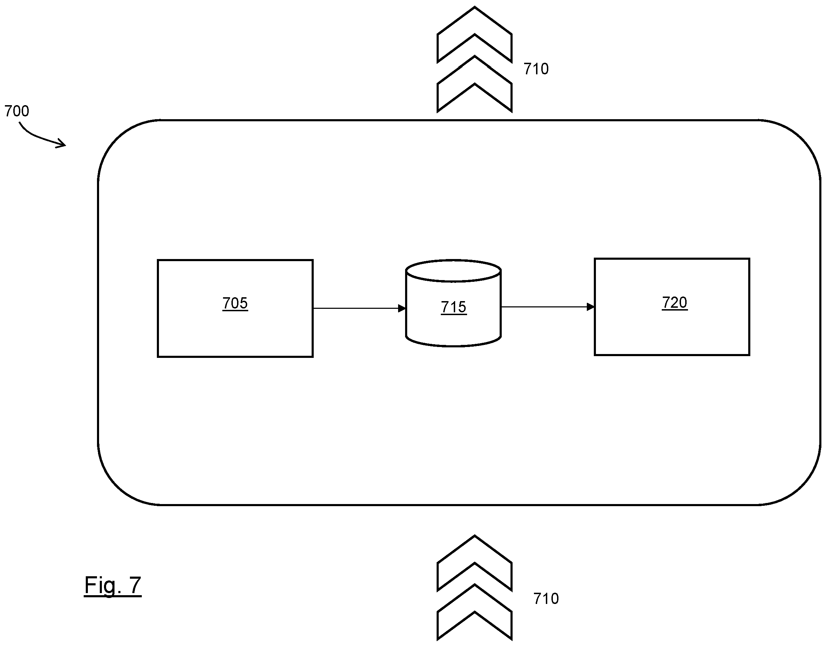

Fig. 7 schematically shows in terms of a simplified block diagram an electronic system 700 comprising a thermoelectric converter according to an embodiment of the present disclosure.

The system 700 comprises a thermoelectric converter 705, for example a thermoelectric generator, adapted to convert heat, represented by the arrows 710, in an environment in which the system 700 is located, into electric energy which is exploited to charge a battery 715 of the system 700. The battery 715 supplies electric energy to an application 720, *e.g.,* an electronic subsystem such as a smart watch, a wearable device, a torch, and so on.

The proposed solution exhibits several advantages. It is easy to industrialize, provides power levels of the order of mA, has a low consumption of semiconductor area, and works with low or high temperature differences. Moreover, the proposed solution allows the size of standard thermoelectric devices to be reduced from macroscale to microscale and exploiting technological steps typical of semiconductor (Silicon) manufacturing technology.

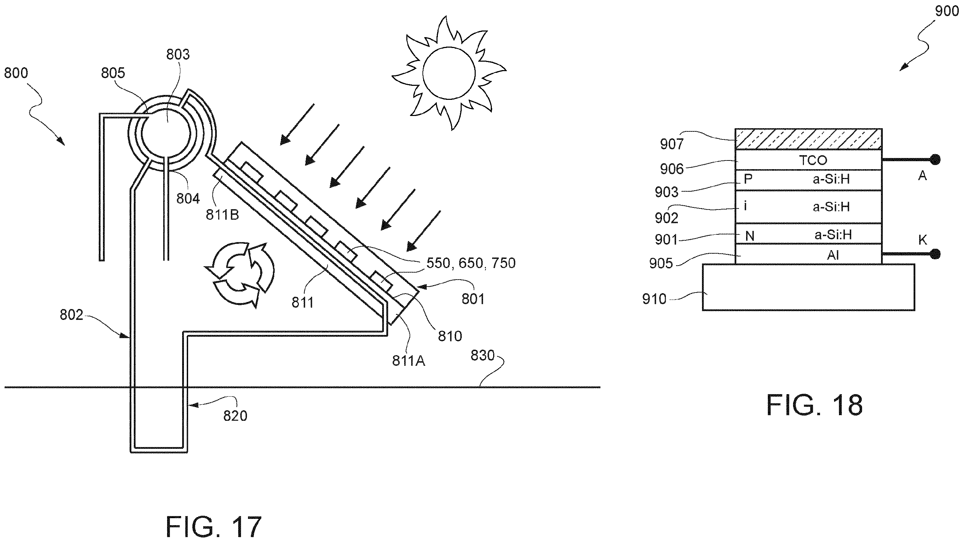

The thermoelectric converter according to the present disclosure can be exploited in several practical applications, such as wearable and fitness gears, pedometers and heart-rate meters, smart watches and wrist bands, wireless sensor nodes for smart homes and cities, as well as in other energy harvesting systems, as discussed below with reference to Fig. 17.

Furthermore, the thermoelectric converter according to the present disclosure may be used in solar energy recovery devices, as disclosed herein.

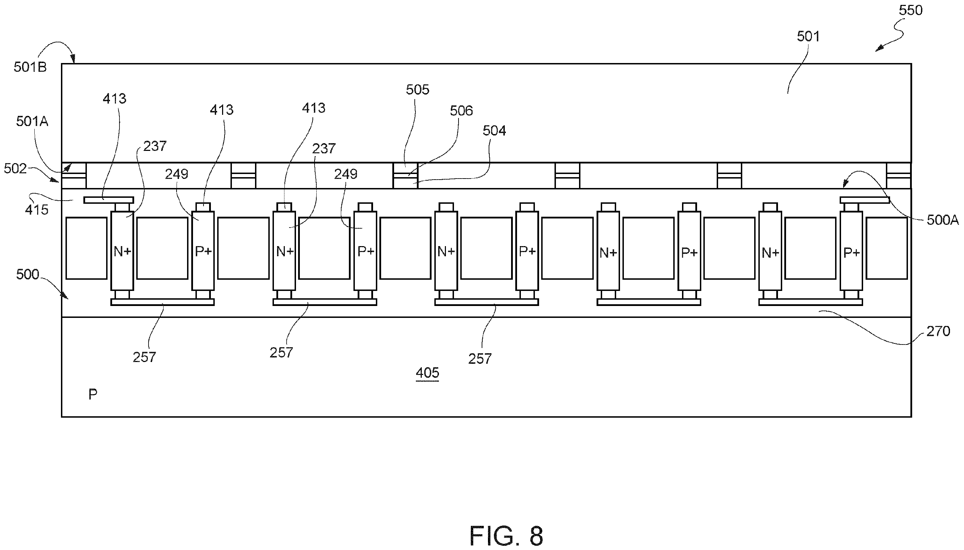

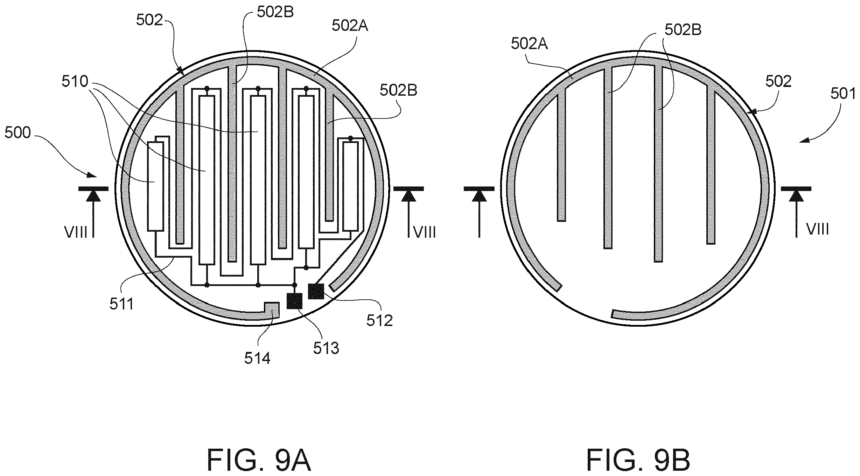

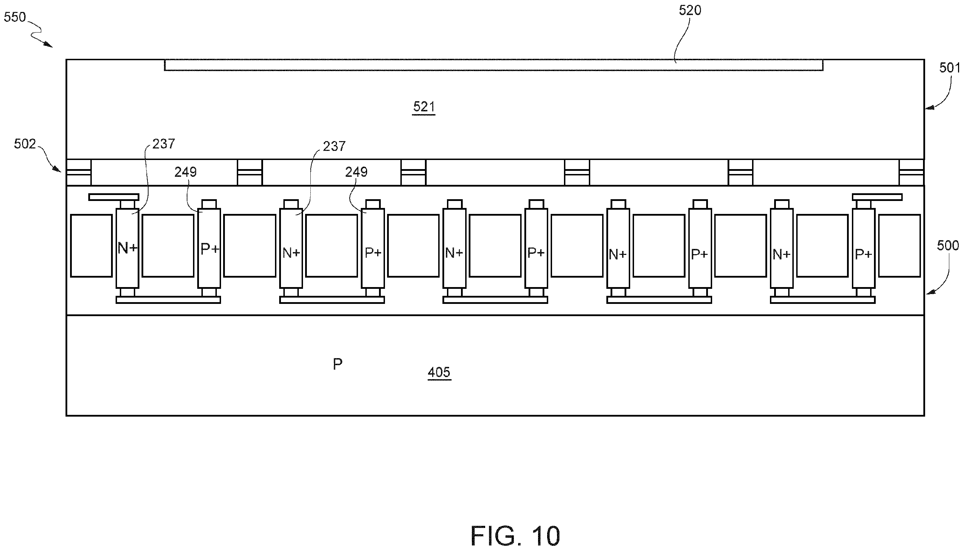

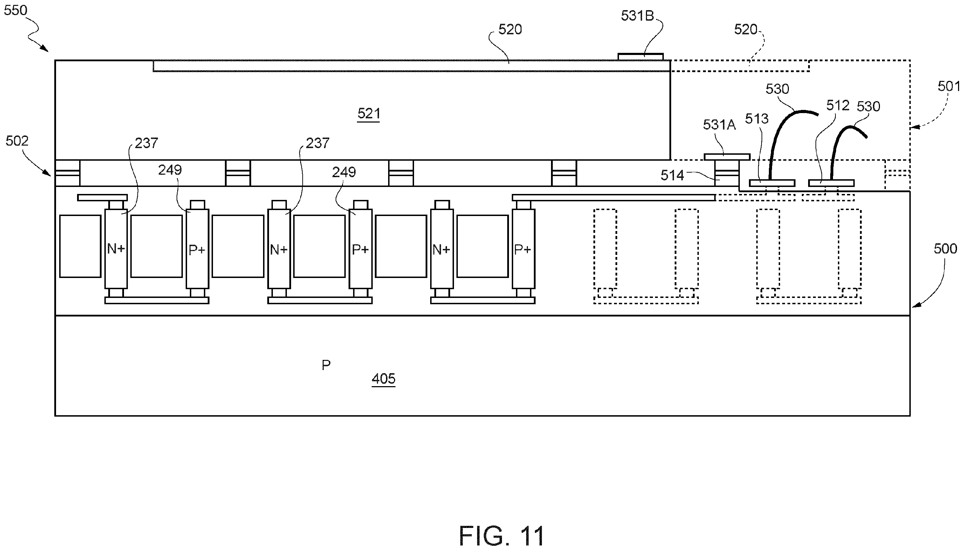

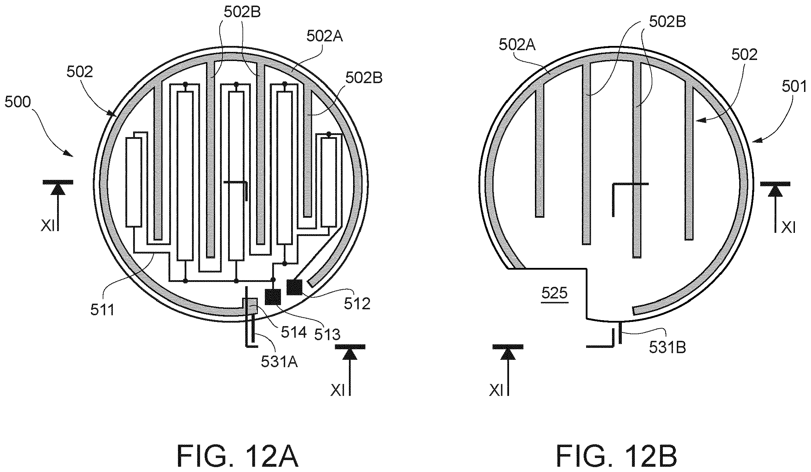

Figs. 8 to 13 show some steps of a method according to an example embodiment of the present disclosure for manufacturing a solar energy recovery device using the thermoelectric converter of any one of the previously described embodiments. Despite the steps of the fabrication method which will be described hereafter apply as well to any of the embodiments described so far, for simplicity they will be described and shown as a continuation of the process steps described with reference to Figs. 4A to 4D and 4F. In the cross-sections of Figs. 8, 10 (taken along cross-section plane VIII-VIII of Figs. 9A, 9B) and in the cross-section of Fig. 11 (taken along cross-section plane XI-XI of Figs. 12A, 12B), only the first conductive lines 257 are completely visible; second conductive lines 413 are visible only in part.

As shown in Fig. 8, a third silicon wafer 501 is bonded to a surface 500A of the structure of Fig. 4F, here denoted by 500 and also called thermoelectric generator structure 500; surface 500A is opposite to the second silicon wafer 405. The third silicon wafer 501 may be a silicon wafer, in particular monocrystalline silicon, doped with acceptor dopants, thus of P type, and has a first surface 501A and a second surface 501B. The third silicon wafer 501 is bonded to thermoelectric generator structure 500 at its first surface 501A.

To this end, a bonding multilayer 502 is used; for example, bonding multilayer 502 may include a first bonding layer 504 extending on surface 500A of thermoelectric generator structure 500; a second bonding layer 505 extending on first surface 501A of the third silicon wafer 501; and an intermediate bonding layer 506. The material of the first bonding layer 504 and of the second bonding layer 505 may be copper (Cu); the material of intermediate bonding layer 506 may be tin (Sn).

The first bonding layer 504, the second bonding layer 505 and the intermediate bonding layer 506 may be applied on either the surface 500A of thermoelectric generator structure 500 or on the first surface 501A of the third silicon wafer 501. In the alternative, the first bonding layer 504 may be applied to the surface 500A of thermoelectric generator structure 500, the second bonding layer 505 may be applied to the first surface 501A of the third silicon wafer 501 and the intermediate bonding layer 506 may be applied on one of the latter.

In some embodiments, the bonding multilayer 502 is defined to form an annular portion 502A surrounding the area accommodating the thermoelectric elements 237, 249 in the thermoelectric generator structure 500 (see also Figs. 9A and 9B). The bonding multilayer 502 further forms intermediate finger-like portions 502B that may be arranged in various ways in order to allow a good bonding and to allow connections to extend on surface 500A of thermoelectric generator structure 500 or on the first surface 501A of the third silicon wafer 501.

For example, the thermoelectric elements 237, 249 of Fig. 8 form a plurality of thermoelectric modules 510 (see Fig. 9A), coupled in parallel to each other. In the embodiment of Figs. 8, 10 and 11, each thermoelectric module 510 may comprise one row thermoelectric elements 237 and one row of thermoelectric elements 249 (see, *e.g.,* Fig. 6), coupled as also shown in Fig. 6; in the alternative, each thermoelectric module 510 may comprise the entire structure shown in *e.g.,* Fig. 6.

In some embodiments, the thermoelectric modules 510 are coupled by connections 511 that may be formed partly in the oxide layer 270 and partly on the oxide layer 415 (Fig. 8). Connections 511 are coupled to an input pad 512 and to an output pad 513 arranged on the periphery of the thermoelectric generator structure 500 in an interruption of the annular portion 502A of bonding multilayer 502. Input pad 512 and output pad 513 may be coupled to input contact pad 413' and to output contact pad 413" of fig. 6 by vias, in a per se known manner. In addition, the annular portion 502A forms a anode pad 514, as explained hereinafter.

In Fig. 10, an implant of N⁺-type doping species is performed in the third wafer 501 through the second surface 501B thereof. For example, suitable N⁺-type doping species may be phosphorus or arsenic.

Then, the implant is annealed and activated by a powerful laser beam pulse. The pulse length may be in the order of a hundred nanosecond (< 200 ns). Thereby, cathode region 520 is formed. The heat generated by the pulse is enough for local annealing, eliminating local implantation damages and activating the dopants. In particular, using a very short pulse, no temperature change is produced in the metal regions; thereby, the bonding multilayer 502, the first and second conductive lines 257, 413 and the connections 511 are not affected.

Cathode region 520 forms, together with the underlying portion of the third wafer 501 (also called hereinafter substrate 521, of P-type), a diode that is able to convert solar energy into a current, in a per se known manner. Thereby, the third wafer 501 forms a solar photovoltaic cell wafer 201.

In Fig. 11, the third wafer 501 is etched, to remove a portion thereof overlying pads 512-514 (see also Figs. 12A, 12B showing the thermoelectric generator structure 500 and the third wafer 501 as if there were not yet bonded). Etching may be performed by laser or blade cutting. Thereby, a recess 525 is formed that exposes pads 512-514.

Wires 530 are bonded to the input and output pads 512, 513 and external connections 531A, 531B are bonded to the anode pad 514 and to the cathode region 520, respectively. The external connections 531A, 531B may be wires or cables.

Thereby, a solar photovoltaic-thermoelectric module 550 is obtained.

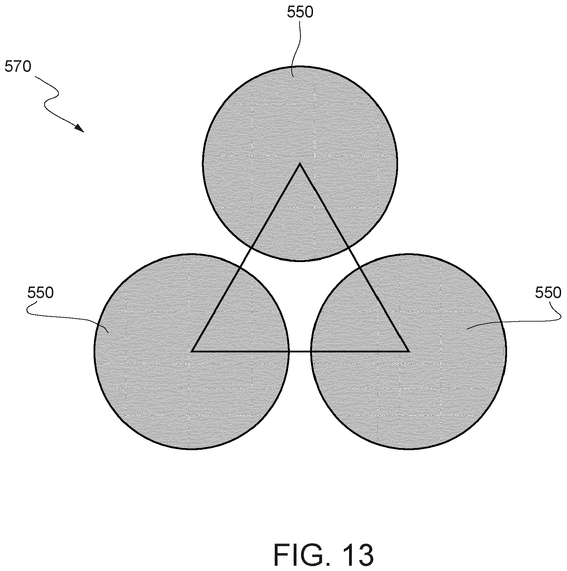

Fig. 13 shows an example connection of three solar photovoltaic-thermoelectric modules 550 to form a hybrid solar energy recovery device 570. In general, a plurality of solar photovoltaic-thermoelectric modules 550 may be coupled to each other in series or in parallel, with the input pads 512 of all solar photovoltaic-thermoelectric modules 550 coupled together and the output pads 513 of all solar photovoltaic-thermoelectric modules 550 coupled together, through respective external connections 531A, 531B.

Hybrid solar photovoltaic-thermoelectric device 570 is able to efficiently recover electric energy.

Conventional solar cells are able to absorb photon energy of the solar radiation only at frequencies that are near the solar cell band-gap and the remaining energy is converted into thermal energy and wasted. In addition, the conversion efficiency drops with temperature.

Vice versa, with the solar photovoltaic-thermoelectric modules of Figs. 8-12, waste heat produced at the solar photovoltaic cell wafer 501 may be recovered by the thermoelectric generator structure 500 and the total power is the sum of the power supplied by the thermoelectric generator 500 and the power supplied by the solar photovoltaic cell wafer 501, thereby providing a synergetic effect.

Manufacturing may be made using usual techniques in the semiconductor industry. For example, the solar photovoltaic cell wafer 501 is bonded before front end. In this way, possible breakages (for example of metal regions) that may occur during bonding due to the pressure exerted by the piston on the two wafers are avoided.

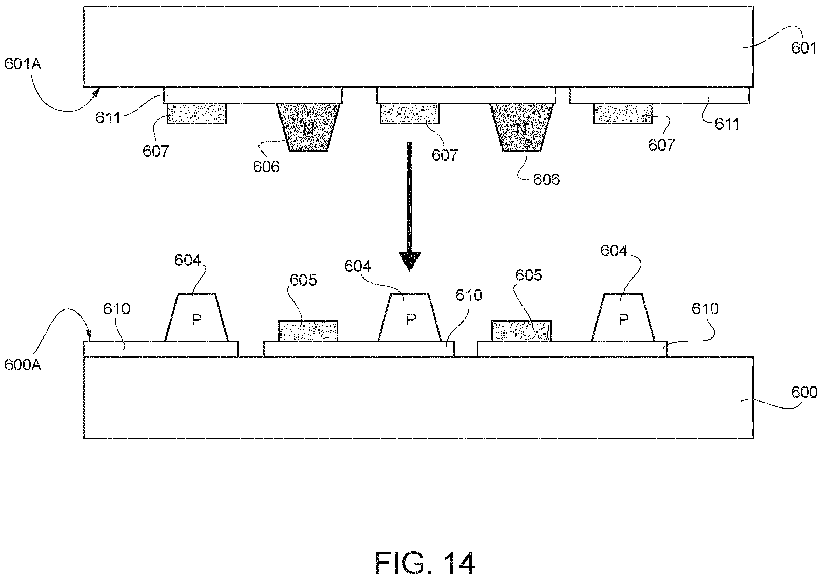

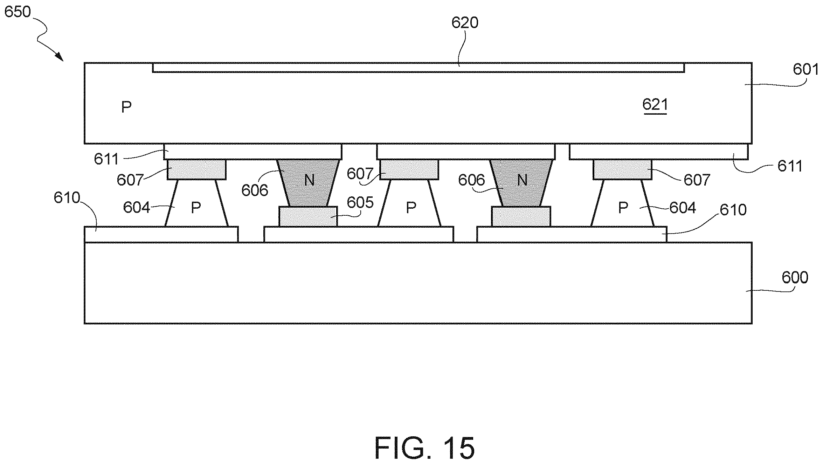

Figs. 14 and 15 show a thermoelectric generator, obtained by aerosol-jet printing of a semiconductor material. material which does not form part of the present invention. In particular, Maskless Mesoscale Material Deposition (M3D) may be used for depositing the semiconductor material. According to one aspect bismuth telluride (Bi₂Te₃) regions of opposite conductivity type are printed.

For example, Fig. 14 shows a first wafer 600 and a second wafer 601. First and second wafers 600, 601 may be silicon wafers, for example monocrystalline silicon wafers. One of the wafers 600, 601, here second wafer 601, is P-type.

First wafer 600 has a surface 600A on which alternatively P-type bismuth telluride regions 604 and first adhesion regions 605 have been deposited using M3D.

Second wafer 601 has a surface 601A on which alternatively N-type bismuth telluride regions 606 and second adhesion regions 607 have been deposited using M3D.

P-type bismuth telluride regions 604 and first adhesion regions 605 are deposited on first metal regions 610 extending on the surface 600A of the first wafer 600. N-type bismuth telluride regions 606 and second adhesion regions 607 are deposited on second metal regions 611. First and second metal regions 610, 611 may be, for example, of gold (Au).

For example, a bismuth telluride region 604 or 606 and an adhesion region 605 or 607 are formed on each metal region 610 and the distance between a P-type bismuth telluride region 604 and the adjacent first adhesion regions 605 is the same as the distance between an N-type bismuth telluride region 606 and the adjacent second adhesion regions 607.

In addition, although completely visible in Figs. 14-15, metal regions 610, 611 typically have the pattern shown in Fig. 5 or 6 for the conductive lines 143 or 257 and 413 for connecting the bismuth telluride regions 604, 606 in series. Adhesion regions 605 and 607 may be a tin-silver (Sn-Ag) alloy and have a lower thickness than the bismuth telluride regions 604, 606. Bismuth telluride regions 604, 606 have here the same thickness, for example in the range 20-30 µm; adhesion regions 605, 607 have the same thickness, for example in the range 1-2 µm.

First and second wafers 600, 601 are bonded to each other by turning one wafer (here second wafer 601) upside down and bonding the P-type bismuth telluride regions 604 to the second adhesion regions 607 and the N-type bismuth telluride regions 606 to the first adhesion regions 605, Fig. 15.

Bonding may be done by applying a pressure (e.g. 1-20 MPa) at a low temperature, *e*.*g*., about 400°C.

After bonding, bismuth telluride regions 604, 606 form thermoelectric elements.

Then, an implant of N⁺-type doping species is performed in one of the wafers 600, 601, here second wafer 601, through its exposed surface. For example, phosphorus or arsenic ions are implanted.

Then, the implant is annealed and activated by a powerful laser beam pulse, forming cathode region 620. The rest of the second wafer 601 forms an anode region 621.

The structure of Fig. 15 may be subject to the manufacturing step discussed above with reference to Figs. 11, 12A and 12B

Thereby, a solar photovoltaic-thermoelectric module 650 is obtained.

A plurality of solar photovoltaic-thermoelectric modules 650 may be coupled as shown in Fig. 13, to form a hybrid solar energy recovery device.

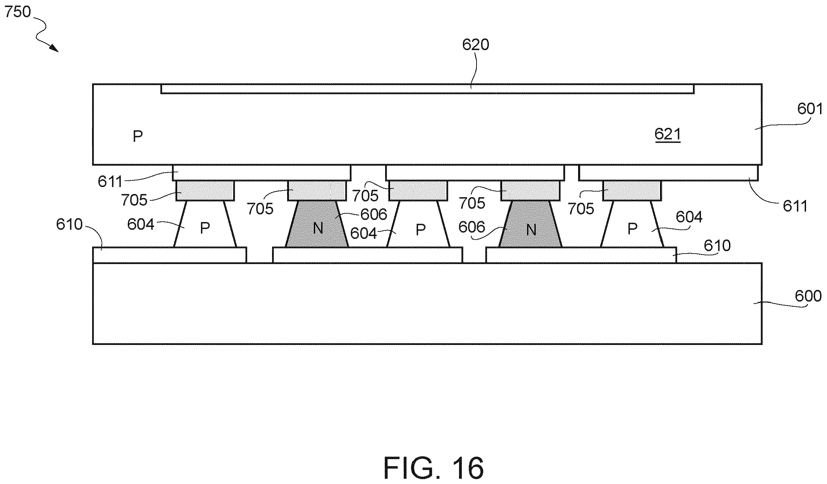

Fig. 16 shows a solar photovoltaic-thermoelectric module 750 that is similar to solar photovoltaic-thermoelectric module 650 of Fig. 15 but for the arrangement of the bismuth telluride regions 604, 606 that are here all formed on a same wafer, here the first wafer 600 and the adhesion regions, here denoted by reference number 705, that are all formed on the other wafer, here the second wafer 601.The other elements have been denoted by same reference numbers of Figs. 14-15.

In some implementations, in the embodiment of Fig. 16, through a M3D printing technique, both P-type and N-type bismuth telluride regions 604, 606 are printed on the first wafer 600 (after forming the first metal regions 610), and the adhesion regions 705 are printed all on the second wafer 601 (after forming the second metal regions 611).

After bonding the first and second wafers 600, 601, the solar photovoltaic-thermoelectric module 750 is obtained.

The energy recovered by solar photovoltaic-thermoelectric module 650 of Fig. 15 or the solar photovoltaic-thermoelectric module 750 of Fig. 16 may be increased by the use of a passive cooling system, as shown in Fig. 17.

Fig. 17 shows a solar energy recovery system 800 comprising a solar collector panel 801 and a loop 802 for recirculating a cooling fluid. In the considered system, the cooling fluid is water and the following description is made considering water; other cooling fluids may however be used.

A tank 803, having a cold water input tap 804 and a warm water output tap 805, is arranged along the water recirculation loop 802.

The solar collector panel 801 accommodates a plurality of solar photovoltaic-thermoelectric modules 550, 650 or 750, coupled together as shown in Figure 13. The solar photovoltaic-thermoelectric modules 550, 650 or 750 may be attached to a support wall 810 that delimits a water chamber 811 arranged along the loop 802. The water chamber 811 has an input (cold) side 811A and an output (warm) side 811B; the tank 803 is arranged near the output (warm) side 811B of the water chamber 811.

The water in the loop 802 circulate without the need of pumps, due to the temperature gradient between the input (cold) side 811A and the output (warm) side 811B, as well as because of the principle of communication vessels.

For example, the loop 802 may include an underground section 820 that extends under the ground level (indicated by 830 in Fig. 17). In particular, by arranging underground section 820 at a depth of 8-10 m below the ground level 830, a particularly efficient extraction of heat from the cooling water is obtained, and no refrigeration machine or pump is needed.

The loop 802, by recirculating the cooling water, provides a cooling of the solar collector panel 801 and thus a reduction in the temperature of the solar photovoltaic cell wafers 501, 601 as well as an increase in the photovoltaic effect.

Fig. 18 shows a possible embodiment of a solar photovoltaic cell wafer 900.

Solar photovoltaic cell wafer 900 is based on the use of amorphous silicon, in case passivated by hydrogen (a-Si:H) and comprises a stack formed by a first doped layer 901, having an N-type conductivity; an intermediate, intrinsic layer 902, overlying the first doped layer 901; and a second doped layer 903, having a P-type conductivity, overlying the intermediate, intrinsic layer 902.

For example, the structure of Fig. 18 may be obtained starting from the structure of Fig. 8, by depositing, above the third wafer 501, an aluminum layer 905, the first doped layer 901, the intermediate, intrinsic layer 902, the second doped layer 903, a transparent conductive oxide (TCO) layer 906, and a glass layer 907.

In an embodiment, the first doped layer 901 may have a thickness of about 10 nm; the intermediate, intrinsic layer 902 may have a thickness of about 400 nm; and the second doped layer 901 may have a thickness of about 10 nm.

The TCO layer 906 may be, e.g., of indium-tin oxide.

The intermediate, intrinsic layer 902 provides for an efficient absorption of light radiation, while the first and second doped layers 901, 903 provide an efficient generation of an electronic current, due to the fact that the electron-hole recombination is particularly high in doped silicon. The solar photovoltaic cell wafer 900 is thus very efficient and may advantageously combined with the thermoelectric generator structure described herein, for example with thermoelectric generator structure 500.

## Claims

1. A method of fabricating a thermoelectric converter, comprising:
forming a plurality of first thermoelectrically active elements (133a; 237; 330a) of a first thermoelectric semiconductor material having a first Seebeck coefficient and a plurality of second thermoelectrically active elements (133b; 249; 330b) of a second thermoelectric semiconductor material having a second Seebeck coefficient in a layer (115; 215) of silicon-based material, the layer of the silicon-based material having a first surface, a second surface opposite to the first surface, and a first thickness between the first surface and the second surface, the first and second thermoelectrically active elements each being formed to extend through the first thickness, from the first surface to the second surface; and
forming electrically conductive interconnections (143, 413; 257, 413) over at least one of the first surface or the second surface of the layer of the silicon-based material (115; 215), the electrically conductive interconnections each electrically interconnecting a first thermoelectrically active element of the plurality of first thermoelectrically active elements and a corresponding one of the plurality of second thermoelectrically active elements; and forming an input electrical terminal and an output electrical terminal electrically coupled to the electrically conductive interconnections,
wherein the first thermoelectric semiconductor material includes porous silicon and the second thermoelectric semiconductor material includes a silicon-based material selected from a group consisting of porous silicon and polycrystalline silicon.

2. The method of claim 1, wherein the layer (115; 215) of the silicon-based material is a material selected among polycrystalline SiGe having a material composition of Si_{0.7}Ge_{0.3}, or epitaxial polycrystalline silicon.

3. The method of claim 1 or 2, wherein the plurality of first thermoelectrically active elements (133a; 237; 330a) of the first thermoelectric semiconductor material having a first Seebeck coefficient are doped with acceptor dopants, and the plurality of second thermoelectrically active elements (133b; 249; 330b) of the second thermoelectric semiconductor material having a second Seebeck coefficient are doped with donor dopants.

4. The method of any one of the preceding claims, wherein the layer of the silicon-based material is polycrystalline silicon, and the method comprises growing epitaxially the layer (115; 215) of polycrystalline silicon on an oxidized surface of a substrate.

5. The method of claim 4, wherein the forming the plurality of first thermoelectrically active elements (237) of the first thermoelectric semiconductor material having the first Seebeck coefficient comprises:
forming first trenches (225, 230) in the layer of the silicon-based material, and
filling the first trenches with polycrystalline silicon doped with acceptor dopants; and
wherein the forming the plurality of second thermoelectrically active elements of the second thermoelectric semiconductor material having the second Seebeck coefficient comprises:
forming second trenches (240, 245) in the layer (215) of the silicon-based material, and
filling the second trenches with polycrystalline silicon doped with donor dopants and
converting the doped polycrystalline silicon filling the first and second trenches into doped porous silicon.

6. The method of the preceding claim, wherein converting the doped polycrystalline silicon comprises forming anisotropic porous silicon.

7. The method of any one of the preceding claims, further comprising:
bonding the layer of silicon-based material to a wafer (501) intended to form solar photovoltaic cells.

8. The method of the preceding claim, wherein bonding the layer of silicon-based material comprises forming a conductive bonding layer (513) in electrical contact with the wafer (501) and forming a first electrical contact for wafer (501).

9. The method of the preceding claim, wherein the wafer (501) comprises a first region (521) of a first conductivity type, the method including implanting doping species to form a second region (520) of a second conductivity type, opposite to the first conductivity type, and forming a second electrical contact (531) electrically coupled to the second region.

10. An integrated thermoelectric converter, comprising:
a first column structure (133a; 237; 330a), the first column structure including porous silicon doped with a first conductivity type;
a second column structure (133b; 249; 330b), the second column structure including one of porous silicon, or polycrystalline silicon and doped with a second conductivity type; and
a first electrically conductive interconnection structure (143, 413; 257, 413; 257') in electrical contact with a first end of the first column structure and a first end of the second column structure.

11. The integrated thermoelectric converter of the preceding claim, comprising a first insulation structure (230) surrounding the first column structure (237) and a second insulation structure (230) surrounding the second column structure (249).

12. The integrated thermoelectric converter of the preceding claim, wherein the first and second column structures include anisotropic silicon.

13. The integrated thermoelectric converter of claim 10, comprising a substrate, wherein the first column structure includes a first portion of porous silicon and a second portion of polycrystalline silicon, the second portion between the first portion and the substrate.

## Patentansprüche

1. Verfahren zum Herstellen eines thermoelektrischen Wandlers, umfassend:
Bilden einer Vielzahl von ersten thermoelektrisch aktiven Elementen (133a; 237; 330a) aus einem ersten thermoelektrischen Halbleitermaterial, das einen ersten Seebeck-Koeffizienten aufweist, und einer Vielzahl von zweiten thermoelektrisch aktiven Elementen (133b; 249; 330b) aus einem zweiten thermoelektrischen Halbleitermaterial, das einen zweiten Seebeck-Koeffizienten aufweist, in einer Schicht (115; 215) aus siliziumbasiertem Material, wobei die Schicht aus siliziumbasiertem Material eine erste Oberfläche aufweist, eine zweite Oberfläche, die der ersten Oberfläche gegenüberliegt, und eine erste Dicke zwischen der ersten Oberfläche und der zweiten Oberfläche, wobei die ersten und zweiten thermoelektrisch aktiven Elemente jeweils ausgebildet sind, um sich durch die erste Dicke von der ersten Oberfläche zur zweiten Oberfläche zu erstrecken; und
Bilden von elektrisch leitfähigen Durchschaltungen (143, 413; 257, 413) über mindestens einer von der ersten Oberfläche oder der zweiten Oberfläche der Schicht aus siliziumbasiertem Material (115; 215), wobei die elektrisch leitfähigen Durchschaltungen jeweils ein erstes thermoelektrisch aktives Element der Vielzahl von ersten thermoelektrisch aktiven Elementen und ein entsprechendes der Vielzahl von zweiten thermoelektrisch aktiven Elementen elektrisch durchschalten; und Bilden eines elektrischen Eingangsanschlusses und eines elektrischen Ausgangsanschlusses, die elektrisch mit den elektrisch leitfähigen Durchschaltungen gekoppelt sind,
wobei das erste thermoelektrische Halbleitermaterial poröses Silizium enthält und das zweite thermoelektrische Halbleitermaterial ein siliziumbasiertes Material enthält, das aus einer Gruppe ausgewählt ist, die aus porösem Silizium und polykristallinem Silizium besteht.

2. Verfahren nach Anspruch 1, wobei die Schicht (115; 215) aus siliziumbasiertem Material ein Material ist, das ausgewählt ist aus polykristallinem SiGe, das eine Materialzusammensetzung von Si_{0,7}Ge_{0,3} oder epitaktisches polykristallines Silizium aufweist.

3. Verfahren nach Anspruch 1 oder 2, wobei die Vielzahl von ersten thermoelektrisch aktiven Elementen (133a; 237; 330a) des ersten thermoelektrischen Halbleitermaterials, das einen ersten Seebeck-Koeffizienten aufweist, mit Akzeptordotierstoffen dotiert ist, und die Vielzahl von zweiten thermoelektrisch aktiven Elementen (133b; 249; 330b) des zweiten thermoelektrischen Halbleitermaterials, das einen zweiten Seebeck-Koeffizienten aufweist, mit Donordotierstoffen dotiert ist.

4. Verfahren nach einem der vorhergehenden Ansprüche, wobei die Schicht aus siliziumbasiertem Material polykristallines Silizium ist, und das Verfahren das epitaktische Wachsen der Schicht (115; 215) aus polykristallinem Silizium auf einer oxidierten Oberfläche eines Substrats umfasst.

5. Verfahren nach Anspruch 4, wobei das Bilden der Vielzahl von ersten thermoelektrisch aktiven Elementen (237) des ersten thermoelektrischen Halbleitermaterials, das den ersten Seebeck-Koeffizienten aufweist, umfasst:
Bilden von ersten Schneisen (225, 230) in der Schicht aus siliziumbasiertem Material, und
Ausfüllen der ersten Schneisen mit polykristallinem Silizium, das mit Akzeptordotierstoffen dotiert ist; und
wobei das Bilden der Vielzahl von zweiten thermoelektrisch aktiven Elementen des zweiten thermoelektrischen Halbleitermaterials, das den zweiten Seebeck-Koeffizienten aufweist, umfasst:
Bilden von zweiten Schneisen (240, 245) in der Schicht (215) aus siliziumbasiertem Material, und
Ausfüllen der zweiten Schneisen mit polykristallinem Silizium, das mit Donordotierstoffen dotiert ist, und
Umwandeln des dotierten polykristallinen Siliziums, das die ersten und zweiten Schneisen ausfüllt, in dotiertes poröses Silizium.

6. Verfahren nach dem vorhergehenden Anspruch, wobei das Umwandeln des dotierten polykristallinen Siliziums das Bilden von anisotropem porösem Silizium umfasst.

7. Verfahren nach einem der vorhergehenden Ansprüche, ferner umfassend:
Bonden der Schicht aus siliziumbasiertem Material mit einem Wafer (501), der dazu bestimmt ist, Solarphotovoltaikzellen zu bilden.

8. Verfahren nach dem vorhergehenden Anspruch, wobei das Bonden der Schicht aus siliziumbasiertem Material das Bilden einer leitfähigen Bondingschicht (513) in elektrischem Kontakt mit dem Wafer (501) und das Bilden eines ersten elektrischen Kontakts für den Wafer (501) umfasst.

9. Verfahren nach dem vorhergehenden Anspruch, wobei der Wafer (501) einen ersten Bereich (521) eines ersten Leitfähigkeitstyps umfasst, und das Verfahren das Implantieren von Dotierungsspezien enthält, um einen zweiten Bereich (520) eines zweiten Leitfähigkeitstyps zu bilden, der dem ersten Leitfähigkeitstyp entgegengesetzt ist, und einen zweiten elektrischen Kontakt (531) zu bilden, der elektrisch mit dem zweiten Bereich gekoppelt ist.

10. Integrierter thermoelektrischer Wandler, umfassend:
eine erste Säulenstruktur (133a; 237; 330a), wobei die erste Säulenstruktur poröses Silizium enthält, das mit einem ersten Leitfähigkeitstyp dotiert ist;
eine zweite Säulenstruktur (133b; 249; 330b), wobei die zweite Säulenstruktur eines enthält aus porösem Silizium oder polykristallinem Silizium, und mit einem zweiten Leitfähigkeitstyp dotiert ist; und
eine erste elektrisch leitfähige Durchschaltungsstruktur (143, 413; 257, 413; 257'), die in elektrischem Kontakt mit einem ersten Ende der ersten Säulenstruktur und einem ersten Ende der zweiten Säulenstruktur steht.

11. Integrierter thermoelektrischer Wandler nach dem vorhergehenden Anspruch, eine erste Isolationsstruktur (230) umfassend, die die erste Säulenstruktur (237) umgibt, und eine zweite Isolationsstruktur (230), die die zweite Säulenstruktur (249) umgibt.

12. Integrierter thermoelektrischer Wandler nach dem vorhergehenden Anspruch, wobei die erste und die zweite Säulenstruktur anisotropes Silizium enthalten.

13. Integrierter thermoelektrischer Wandler nach Anspruch 10, ein Substrat enthaltend, wobei die erste Säulenstruktur einen ersten Abschnitt aus porösem Silizium und einen zweiten Abschnitt aus polykristallinem Silizium umfasst, und der zweite Abschnitt zwischen dem ersten Abschnitt und dem Substrat liegt.

## Revendications

1. Procédé de fabrication d'un convertisseur thermoélectrique, comprenant les étapes suivantes :
former une pluralité de premiers éléments thermoélectriquement actifs (133a ; 237 ; 330a) avec un premier matériau semiconducteur thermoélectrique ayant un premier coefficient de Seebeck et une pluralité de deuxièmes éléments thermoélectriquement actifs (133b ; 249 ; 330b) avec un deuxième matériau semiconducteur thermoélectrique ayant un deuxième coefficient de Seebeck en une couche (115 ; 215) de matériau à base de silicium, la couche du matériau à base de silicium ayant une première surface, une deuxième surface opposée à la première surface, et une première épaisseur entre la première surface et la deuxième surface, les premiers et deuxièmes éléments thermoélectriquement actifs étant tous formés de manière à s'étendre à travers la première épaisseur, de la première surface à la deuxième surface ; et
former des interconnexions électriquement conductrices (143, 413 ; 257, 413) sur au moins l'une des première surface et deuxième surface de la couche du matériau à base de silicium (115 ; 215), les interconnexions électriquement conductrices reliant chacune électriquement un premier élément thermoélectriquement actif de la pluralité de premiers éléments thermoélectriquement actifs à un élément correspondant de la pluralité de deuxièmes éléments thermoélectriquement actifs ; et former une borne électrique d'entrée et une borne électrique de sortie couplées électriquement aux interconnexions électriquement conductrices,
dans lequel le premier matériau semiconducteur thermoélectrique comprend du silicium poreux et le deuxième matériau semiconducteur thermoélectrique comprend un matériau à base de silicium choisi dans un groupe comprenant le silicium poreux et le silicium polycristallin.

2. Procédé selon la revendication 1, dans lequel la couche (115 ; 215) du matériau à base de silicium est un matériau choisi parmi le SiGe polycristallin ayant une composition de matériau de Si_{0,7}Ge_{0,3}, et le silicium polycristallin épitaxial.

3. Procédé selon la revendication 1 ou 2, dans lequel les éléments de la pluralité de premiers éléments thermoélectriquement actifs (133a ; 237 ; 330a) avec le premier matériau semiconducteur thermoélectrique ayant un premier coefficient de Seebeck sont dopés avec des dopants accepteurs, et les éléments de la pluralité de deuxièmes éléments thermoélectriquement actifs (133b ; 249 ; 330b) avec le deuxième matériau semiconducteur thermoélectrique ayant un deuxième coefficient de Seebeck sont dopés avec des dopants donneurs.

4. Procédé selon l'une quelconque des revendications précédentes, dans lequel la couche du matériau à base de silicium est du silicium polycristallin, et le procédé comprend le fait de faire croître de manière épitaxiale la couche (115 ; 215) de silicium polycristallin sur une surface oxydée d'un substrat.

5. Procédé selon la revendication 4, dans lequel la formation de la pluralité de premiers éléments thermoélectriquement actifs (237) avec le premier matériau semiconducteur thermoélectrique ayant le premier coefficient de Seebeck comprend les étapes suivantes :
former des premières tranchées (225, 230) dans la couche du matériau à base de silicium, et
remplir les premières tranchées de silicium polycristallin dopé avec des dopants accepteurs ; et
dans lequel la formation de la pluralité de deuxièmes éléments thermoélectriquement actifs avec le deuxième matériau semiconducteur thermoélectrique ayant le deuxième coefficient de Seebeck comprend les étapes suivantes :
former des deuxièmes tranchées (240, 245) dans la couche (215) du matériau à base de silicium, et
remplir les deuxièmes tranchées de silicium polycristallin dopé avec des dopants donneurs, et
convertir le silicium polycristallin dopé qui remplit les premières et deuxièmes tranchées en du silicium poreux dopé.

6. Procédé selon la revendication précédente, dans lequel la conversion du silicium polycristallin dopé comprend le fait de former du silicium poreux anisotrope.

7. Procédé selon l'une quelconque des revendications précédentes, comprenant en outre le fait de coller la couche de matériau à base de silicium sur une plaquette (501) destinée à former des cellules solaires photovoltaïques.

8. Procédé selon la revendication précédente, dans lequel le collage de la couche de matériau à base de silicium comprend la formation d'une couche de liaison conductrice (513) en contact électrique avec la plaquette (501) et la formation d'un premier contact électrique pour la plaquette (501).

9. Procédé selon la revendication précédente, dans lequel la plaquette (501) comprend une première région (521) ayant un premier type de conductivité, le procédé comprenant le fait d'implanter des espèces dopantes pour former une deuxième région (520) ayant un deuxième type de conductivité, opposé au premier type de conductivité, et de former un deuxième contact électrique (531) couplé électriquement à la deuxième région.

10. Convertisseur thermoélectrique intégré comprenant :
une première structure de colonne (133a ; 237 ; 330a), la première structure de colonne comprenant du silicium poreux dopé avec un premier type de conductivité ;
une deuxième structure de colonne (133b ; 249 ; 330b), la deuxième structure de colonne comprenant un élément parmi du silicium poreux et du silicium polycristallin et dopé avec un deuxième type de conductivité ; et
une première structure d'interconnexion électriquement conductrice (143, 413 ; 257, 413 ; 257') en contact électrique avec une première extrémité de la première structure de colonne et une première extrémité de la deuxième structure de colonne.

11. Convertisseur thermoélectrique intégré selon la revendication précédente, comprenant une première structure isolante (230) entourant la première structure de colonne (237) et une deuxième structure isolante (230) entourant la deuxième structure de colonne (249).

12. Convertisseur thermoélectrique intégré selon la revendication précédente, dans lequel les première et deuxième structures de colonne comprennent du silicium anisotrope.

13. Convertisseur thermoélectrique intégré selon la revendication 10, comprenant un substrat, dans lequel la première structure de colonne comprend une première partie en silicium poreux et une deuxième partie en silicium polycristallin, la deuxième partie se situant entre la première partie et le substrat.
